# EUROPEAN PATENT APPLICATION

(11) **EP 4 502 002 A1**
(43) Date of publication of application: **05.02.2025**
(21) Application number: 23780031.3
(22) Date of filing: 23.03.2023
(51) Int. Cl.: C08G 63/18, C08L 101/00, H01L 23/29, H01L 23/31, H05K 1/03

(54) **ACTIVE ESTER RESIN**

(30) Priority: 29.03.2022 JP 2022053381
(71) Applicant: AJINOMOTO CO., INC., Chuo-ku Tokyo 104-8315 (JP)
(72) Inventor: OGURA, Ichiro, Kawasaki-shi, Kanagawa 210-0801 (JP); SATO, Naoya, Kawasaki-shi, Kanagawa 210-0801 (JP); TANAKA, Shunsuke, Kawasaki-shi, Kanagawa 210-0801 (JP)
(74) Representative: Mewburn Ellis LLP
(86) International application number: PCT/JP2023/011468
(87) International publication number: WO 2023/190020

(57) **Abstract**

In order to provide an active ester resin that is capable of achieving an excellent dielectric dissipation factor in a high temperature environment, an active ester resin comprising one or more of α-methylbenzyl groups per one molecule is provided.

## Description

### Technical Field

The present invention relates to a novel active ester resin and a production method thereof. The present invention relates to a resin crosslinking agent, a resin composition, a cured product, a sheet-shaped laminate material, a resin sheet, a printed wiring board, a semiconductor chip package, and a semiconductor device, which are all obtained using the active ester resin.

### Background Art

A resin composition containing a crosslinkable resin such as an epoxy resin and a crosslinking agent (curing agent) for it has been widely used as a material for an electronic component such as a semiconductor chip package and a printed circuit board because with this a cured product having excellent properties such as an insulating property can be obtained.

On the other hand, a high speed communication, such as a fifth generation mobile communication system (5G), is required to have a reduced transmission loss when operating in a high frequency environment. In order to reduce such transmission loss, an insulating material having excellent dielectric properties (low dielectric constant and low dielectric dissipation factor) is wanted. As for the insulating material that realizes superior dielectric properties, for example, a resin composition containing an active ester resin has been disclosed in Patent Literatures 1 to 4.

### Citation List

### Patent Literature

Patent Literature 1: WO 2012-002119
Patent Literature 2: WO 2014-061450
Patent Literature 3: WO 2016-098488
Patent Literature 4: Japanese Patent Application Laid-open No. 2012-12534

### Summary of the Invention

### Technical Problem

Compared to resin compositions containing a crosslinking agent such as a phenol type crosslinking agent, resin compositions containing a conventional active ester resin described in Patent Literatures 1 to 4 can have an excellent dielectric dissipation factor in a normal temperature environment. However, it is difficult for those conventional active ester resins to achieve a satisfactory level of a dielectric dissipation factor in a high temperature environment such as, for example, 90°C. In general, an electronic component generates a heat during operation, resulting in a high temperature. From the viewpoint of suppressing a transmission loss during operation, it is desired to develop an active ester resin capable of achieving a low dielectric dissipation factor in a high temperature environment.

The present invention has been devised in view of the aforementioned problems; and thus, the present invention has an object to provide an active ester resin that is capable of achieving an excellent dielectric dissipation factor in a high temperature environment, and a production method of the same, a resin crosslinking agent and a resin composition containing the same, as well as a cured product, a sheet-shaped laminate material, a resin sheet, a printed wiring board, a semiconductor chip package, and a semiconductor device, which all are obtained using the resin composition.

### Solution to Problem

The inventor of the present invention has extensively studied to solve the problems described above. As a result, the inventor has found that the aforementioned problems can be solved by an active ester resin containing an α-methylbenzyl group; based on this finding the present invention has been completed.

Namely, the present invention includes the following aspects.
<1> An active ester resin comprising one or more of α-methylbenzyl groups per one molecule.
<2> The active ester resin according to <1>, including a partial structure represented by the following formula (I): 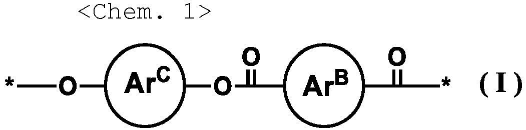 (In the formula (I),
   the group Ar^{B} each independently represents a divalent organic group containing at least one aromatic ring,
   the group Ar^{C} each independently represents a divalent organic group containing at least one aromatic ring, and
   * represents a bond).
<3> The active ester resin according to <1> or <2>, represented by the following formula (II): 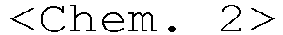 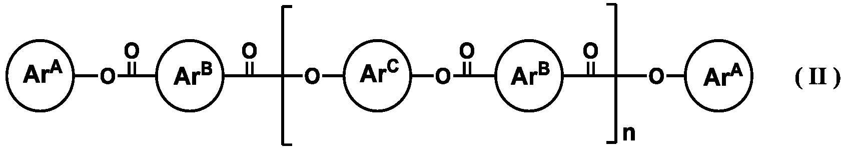 (In the formula (II),
   the group Ar^{A} each independently represents a monovalent organic group containing at least one aromatic ring,
   the group Ar^{B} each independently represents a divalent organic group containing at least one aromatic ring,
   the group Ar^{C} each independently represents a divalent organic group containing at least one aromatic ring,
   at least one of the organic group Ar^{A}, the organic group Ar^{B}, and the organic group Ar^{C} contains the α-methylbenzyl group, and
   n represents a number more than 0).
<4> The active ester resin according to <2> or <3>, wherein the organic group Ar^{C} represents a divalent hydrocarbon group containing at least one aromatic ring.
<5> The active ester resin according to any one of <2> to <4>, wherein the organic group Ar^{C} contains the α-methylbenzyl group.
<6> The active ester resin according to any one of <1> to <5>, including an aromatic ring to which the α-methylbenzyl group is bonded.
<7> The active ester resin according to <6>, wherein on average 1 to 6 α-methylbenzyl groups are bonded to one aromatic ring to which the α-methylbenzyl group is bonded.
<8> The active ester resin according to any one of <1> to <7>, wherein an amount of the α-methylbenzyl group is in a range of 1% by mass to 60% by mass.
<9> The active ester resin according to any one of <1> to <8>, wherein the active ester resin is a condensation reaction product of (X1) an aromatic polyvalent hydroxy compound including (X-1) a modified aromatic polyvalent hydroxy compound containing the α-methylbenzyl group, (X2) an aromatic carboxylic acid compound or an aromatic carboxylic acid halide compound, and (X3) an aromatic monohydroxy compound.
<10> A production method of the active ester resin according to any one of <1> to <9>, the method comprising:
   a step of reacting (X1) an aromatic polyvalent hydroxy compound including (X1-1) a modified aromatic polyvalent hydroxy compound containing the α-methylbenzyl group, (X2) an aromatic carboxylic acid compound or an aromatic carboxylic acid halide compound, and (X3) an aromatic monohydroxy compound.
<11> A resin crosslinking agent comprising the active ester resin according to any one of <1> to <9>.
<12> A resin composition comprising the active ester resin according to any one of <1> to <9> and a crosslinkable resin.
<13> The resin composition according to <12>, wherein the crosslinkable resin includes one or more resins selected from the group consisting of a thermosetting resin and a radical polymerizable resin.
<14> The resin composition according to <12> or <13>, which is for forming an insulating layer of a printed wiring board.
<15> The resin composition according to <12> or <13>, which is for sealing of a semiconductor chip.
<16> A cured product of the resin composition according to any one of <12> to <15>.
<17> A sheet-shaped laminate material comprising the resin composition according to any one of <12> to <15>.
<18> A resin sheet comprising:
   a support, and
   a resin composition layer formed on the support, wherein
   the resin composition layer comprises the resin composition according to any one of <12> to <15>.
<19> A printed wiring board comprising an insulating layer comprising a cured product of the resin composition according to any one of <12> to <15>.
<20> A semiconductor chip package comprising an sealing layer comprising a cured product of the resin composition according to any one of <12> to <15>.
<21> The semiconductor chip package according to <20>, which is a Fan-Out type package.
<22> A semiconductor device comprising the printed wiring board according to <19>.
<23> A semiconductor device comprising the semiconductor chip package according to <20> or <21>.

### Advantageous Effects of Invention

According to the present invention, it is possible to provide an active ester resin that is capable of achieving an excellent dielectric dissipation factor in a high temperature environment, a production method of the same, a resin crosslinking agent and a resin composition containing the same, as well as a cured product, a sheet-shaped laminate material, a resin sheet, a printed wiring board, a semiconductor chip package, and a semiconductor device, which all are obtained using the resin composition.

### Description of Embodiments

### <Explanation of terms>

In the present specification, the term "may have a substituent" as used herein with respect to a compound or a group means both the case where a hydrogen atom of a compound or of a group is not substituted with a substituent, and the case where a part or all of hydrogen atoms of a compound or of a group are substituted with a substituent.

In the present specification, the term "substituent" means, unless otherwise specifically mentioned, a halogen atom, an alkyl group, an alkenyl group, an alkynyl group, an alkapolyenyl group, a cycloalkyl group, a cycloalkenyl group, an alkoxy group, a cycloalkyloxy group, an aryl group, an aryloxy group, an arylalkyl group, an arylalkoxy group, a monovalent heterocyclic group, an alkylidene group, an amino group, a silyl group, an acyl group, an acyloxy group, a carboxy group, a sulfo group, a cyano group, a nitro group, a hydroxy group, a mercapto group, and an oxo group. Groups containing only carbon and hydrogen atoms, such as an alkyl group, an alkenyl group, an alkynyl group, an alkapolyenyl group, a cycloalkyl group, a cycloalkenyl group, an aryl group, an arylalkyl group, and an alkylidene group may be collectively referred to as a "hydrocarbon group". An aliphatic hydrocarbon group having an unsaturated bond such as an alkenyl group, an alkynyl group, an alkapolyenyl group, and a cycloalkenyl group may be collectively referred to as an "unsaturated aliphatic hydrocarbon group".

The substituents listed above may further have a substituent (this may be referred to as a "secondary substituent"). The secondary substituent may be the same as the substituents listed above, unless otherwise specifically mentioned.

In the present specification, unless otherwise specifically mentioned, examples of the halogen atom may include a fluorine atom, a chlorine atom, a bromine atom, and an iodine atom.

In the present specification, unless otherwise specifically mentioned, the alkyl group may be any of linear and branched. The number of the carbon atom in the alkyl group is preferably 1 to 20, more preferably 1 to 14, still more preferably 1 to 12, further still more preferably 1 to **6,** and especially preferably 1 to **3.** Illustrative examples of the alkyl group may include a methyl group, an ethyl group, a propyl group, an isopropyl group, a butyl group, a sec-butyl group, an isobutyl group, a tert-butyl group, a pentyl group, a hexyl group, a heptyl group, an octyl group, a nonyl group, and a decyl group.

In the present specification, unless otherwise specifically mentioned, the alkenyl group may be any of linear and branched. The number of the carbon atom in the alkenyl group is preferably 2 to 20, more preferably 2 to 14, still more preferably 2 to 12, further still more preferably 2 to 6, and especially preferably 2 or 3. Illustrative examples of the alkenyl group may include a vinyl group, an allyl group, a 1-propenyl group, a butenyl group, a sec-butenyl group, an isobutenyl group, a tert-butenyl group, a pentenyl group, a hexenyl group, a heptenyl group, an octenyl group, a nonenyl group, and a decenyl group.

In the present specification, unless otherwise specifically mentioned, the alkynyl group may be any of linear and branched. The number of the carbon atom in the alkynyl group is preferably 2 to 20, more preferably 2 to 14, still more preferably 2 to 12, further still more preferably 2 to 6, and especially preferably 2 or 3. Illustrative examples of the alkynyl group may include an ethynyl group, a propynyl group, a butynyl group, a sec-butynyl group, an isobutynyl group, a tert-butynyl group, a pentynyl group, a hexynyl group, a heptynyl group, an octynyl group, a nonynyl group, and a decynyl group.

In the present specification, unless otherwise specifically mentioned, the alkapolyenyl group may be any of linear and branched, and the number of the double bond thereof is preferably 2 to 10, more preferably 2 to 6, still more preferably 2 to 4, and further still more preferably 2. The number of the carbon atom in the alkapolyenyl group is preferably 3 to 20, more preferably 3 to 14, still more preferably 3 to 12, and further still more preferably 3 to 6.

In the present specification, unless otherwise specifically mentioned, the number of the carbon atom in the cycloalkyl group is preferably 3 to 20, more preferably 3 to 12, and still more preferably 3 to 6. Illustrative examples of the cycloalkyl group may include a cyclopropyl group, a cyclobutyl group, a cyclopentyl group, and a cyclohexyl group.

In the present specification, unless otherwise specifically mentioned, the number of the carbon atom in the cycloalkenyl group is preferably 3 to 20, more preferably 3 to 12, and still more preferably 3 to 6. Illustrative examples of the cycloalkenyl group may include a cyclopropenyl group, a cyclobutenyl group, a cyclopentenyl group, and a cyclohexenyl group.

In the present specification, unless otherwise specifically mentioned, the alkoxy group may be any of linear and branched. The number of the carbon atom in the alkoxy group is preferably 1 to 20, more preferably 1 to 12, and still more preferably 1 to 6. Illustrative examples of the alkoxy group may include a methoxy group, an ethoxy group, a propyloxy group, an isopropyloxy group, a butoxy group, a sec-butoxy group, an isobutoxy group, a tert-butoxy group, a pentyloxy group, a hexyloxy group, a heptyloxy group, an octyloxy group, a nonyloxy group, and a decyloxy group.

In the present specification, unless otherwise specifically mentioned, the number of the carbon atom in the cycloalkyloxy group is preferably 3 to 20, more preferably 3 to 12, and still more preferably 3 to 6. Illustrative examples of the cycloalkyloxy group may include a cyclopropyloxy group, a cyclobutyloxy group, a cyclopentyloxy group, and a cyclohexyloxy group.

In the present specification, unless otherwise specifically mentioned, the aryl group is a group obtained by removing one hydrogen atom on an aromatic ring from an aromatic hydrocarbon. The number of the carbon atom in the aryl group is preferably 6 to 24, more preferably 6 to 18, still more preferably 6 to 14, and further still more preferably 6 to 10. Illustrative examples of the aryl group may include a phenyl group, a naphthyl group, and an anthracenyl group.

In the present specification, unless otherwise specifically mentioned, the number of the carbon atom in the aryloxy group is preferably 6 to 24, more preferably 6 to 18, still more preferably 6 to 14, and further still more preferably 6 to 10. Illustrative examples of the aryloxy group may include a phenoxy group, a 1-naphthyloxy group, and a 2-naphthyloxy group.

In the present specification, unless otherwise specifically mentioned, the number of the carbon atom in the arylalkyl group is preferably 7 to 25, more preferably 7 to 19, still more preferably 7 to 15, and further still more preferably 7 to 11. Illustrative examples of the arylalkyl group may include a phenyl-C₁ to C₁₂ alkyl group, a naphthyl-C₁ to C₁₂ alkyl group, and an anthracenyl-C₁ to C₁₂ alkyl group.

In the present specification, unless otherwise specifically mentioned, the number of the carbon atom in the arylalkoxy group is preferably 7 to 25, more preferably 7 to 19, still more preferably 7 to 15, and further still more preferably 7 to 11. Illustrative examples of the arylalkoxy group may include a phenyl-C₁ to C₁₂ alkoxy group and a naphthyl-C₁ to C₁₂ alkoxy group.

In the present specification, unless otherwise specifically mentioned, a monovalent heterocyclic group refers to a group obtained by removing one hydrogen atom from a heterocyclic ring of a heterocyclic compound. The number of the carbon atom in the monovalent heterocyclic group is preferably 3 to 21, more preferably 3 to 15, and still more preferably 3 to 9. The monovalent heterocyclic group also includes a monovalent aromatic heterocyclic group (heteroaryl group). Illustrative examples of the monovalent heterocyclic may include a thienyl group, a pyrrolyl group, a furanyl group, a furyl group, a pyridyl group, a pyridazinyl group, a pyrimidyl group, a pyrazinyl group, a triazinyl group, a pyrrolidyl group, a piperidyl group, a quinolyl group, and an isoquinolyl group.

In the present specification, unless otherwise specifically mentioned, the alkylidene group is a group in which two hydrogen atoms are removed from the same carbon atom of an alkane. The number of the carbon atom in the alkylidene group is preferably 1 to 20, more preferably 1 to 14, still more preferably 1 to 12, far still more preferably 1 to 6, and especially preferably 1 to 3. Illustrative examples of the alkylidene group may include a methylidene group, an ethylidene group, a propylidene group, an isopropylidene group, a butylidene group, a sec-butylidene group, an isobutylidene group, a tert-butylidene group, a pentylidene group, a hexylidene group, a heptylidene group, an octylidene group, a nonylidene group, and a decylidene group.

In the present specification, unless otherwise specifically mentioned, the acyl group is a group represented by the formula: -C(=O)-R (in the formula, R represents an alkyl group or an aryl group). The alkyl group represented by R may be any of linear and branched. Illustrative examples of the aryl group represented by R may include a phenyl group, a naphthyl group, and an anthracenyl group. The number of the carbon atom in the acyl group is preferably 2 to 20, more preferably 2 to 13, and still more preferably 2 to 7. Illustrative examples of the acyl group may include an acetyl group, a propionyl group, a butyryl group, an isobutyryl group, a pivaloyl group, and a benzoyl group.

In the present specification, unless otherwise specifically mentioned, the acyloxy group is a group represented by the formula: -O-C(=O)-R (in the formula, R represents an alkyl group or an aryl group.). The alkyl group represented by R may be any of linear and branched. Illustrative examples of the aryl group represented by R may include a phenyl group, a naphthyl group, and an anthracenyl group. The number of the carbon atom in the acyloxy group is preferably 2 to 20, more preferably 2 to 13, and still more preferably 2 to 7. Illustrative examples of the acyloxy group may include an acetoxy group, a propionyloxy group, a butyryloxy group, an isobutyryloxy group, a pivaloyloxy group, and a benzoyloxy group.

In the present specification, the term an "organic group" refers to a group containing at least a carbon atom as the skeletal atom, in which the organic group may be any of linear, branched, and cyclic. In the present specification, unless otherwise specifically mentioned, the number of the skeletal atom in the organic group is preferably 1 to 3000, more preferably 1 to 1000, still more preferably 1 to 100, far still more preferably 1 to 50, and especially preferably 1 to 30, or 1 to 20. Illustrative examples of the organic group may include a group composed of one or more skeletal atoms selected from a carbon atom, an oxygen atom, a nitrogen atom, and a sulfur atom (including at least a carbon atom).

In the present specification, the term "hydrocarbon group" refers to a group obtained by removing one or more hydrogen atoms from a hydrocarbon compound. Specifically, a monovalent hydrocarbon group refers to a group obtained by removing one hydrogen atom from a hydrocarbon compound, and a divalent hydrocarbon group refers to a group obtained by removing two hydrogen atoms from a hydrocarbon compound. Examples of the hydrocarbon groups may include a group containing only carbon and hydrogen atoms among aliphatic groups and aromatic groups described below. In the present specification, the aliphatic group containing only carbon and hydrogen atoms may be referred to as "an aliphatic hydrocarbon group", and the aromatic group containing only carbon and hydrogen atoms may be referred to as "an aromatic hydrocarbon group". Illustrative examples of the divalent hydrocarbon group may include an alkylene group, a cycloalkylene group, an alkenylene group, a cycloalkenylene group, an alkapolyenylene group, and an arylene group.

In the present specification, the term "aliphatic group" refers to a group obtained by removing one or more hydrogen atoms that are bonded to an aliphatic carbon of an aliphatic compound. Specifically, a monovalent aliphatic group refers to a group obtained by removing one hydrogen atom that is bonded to an aliphatic carbon of an aliphatic compound, and a divalent aliphatic group refers to a group obtained by removing two hydrogen atoms that are bonded to an aliphatic carbon of an aliphatic compound. Illustrative examples of the monovalent aliphatic group may include an alkyl group that may have a substituent, a cycloalkyl group that may have a substituent, an alkenyl group that may have a substituent, a cycloalkenyl group that may have a substituent, and an alkapolyenyl group that may have a substituent (the number of the double bond is preferably 2 to 10, more preferably 2 to 6, still more preferably 2 to 4, and far still more preferably 2). Illustrative examples of the divalent aliphatic group may include an alkylene group that may have a substituent, a cycloalkylene group that may have a substituent, an alkenylene group that may have a substituent, a cycloalkenylene group that may have a substituent, an alkapolyenylene group that may have a substituent (the number of the double bonds is preferably 2 to 10, more preferably 2 to 6, still more preferably 2 to 4, and far still more preferably 2). In the present specification, unless otherwise specifically mentioned, the number of the carbon atom in the aliphatic group is preferably 1 or more, more preferably 2 or more, and still more preferably 3 or more, 4 or more, 5 or more, or 6 or more, and is preferably 50 or less, more preferably 40 or less, and still more preferably 30 or less, 20 or less, 18 or less, 16 or less, 14 or less, or 12 or less. This number of the carbon atom does not include the number of the carbon atom in the substituent.

In the present specification, the term "aromatic group" refers to a group obtained by removing one or more hydrogen atoms from the aromatic ring of an aromatic compound. Specifically, the monovalent aromatic group refers to a group obtained by removing one hydrogen atom from the aromatic ring of an aromatic compound, and a divalent aromatic group refers to a group obtained by removing two hydrogen atoms from the aromatic ring of an aromatic compound. Illustrative examples of the monovalent aromatic group may include an aryl group that may have a substituent and a heteroaryl group that may have a substituent. Illustrative examples of the divalent aromatic group may include an arylene group that may have a substituent and a heteroarylene group that may have a substituent. In the present specification, unless otherwise specifically mentioned, the number of the carbon atom in the aromatic group is preferably 3 or more, more preferably 4 or more, or 5 or more, and still more preferably 6 or more, and the upper limit thereof is preferably 24 or less, more preferably 18 or less, or 14 or less, and still more preferably 10 or less. This number of the carbon atom does not include the number of the carbon atom in the substituent.

The term "aromatic ring" in the present specification means the ring that obeys the Hückel's rule that the number of electrons in the π-electron system on the ring is 4p + 2 (p is a natural number), including a monocyclic aromatic ring and a fused polycyclic aromatic ring having two or more monocyclic aromatic rings fused together. The aromatic ring may be an aromatic carbon ring including only carbon atoms as the ring constituent atoms, or an aromatic heterocyclic ring including, as the ring constituent atom, a heteroatom such as an oxygen atom, a nitrogen atom and a sulfur atom, in addition to a carbon atom. In the present specification, unless otherwise specifically mentioned, the number of the carbon atom in the aromatic ring is preferably 3 or more, more preferably 4 or more, or 5 or more, still more preferably 6 or more, and the upper limit thereof is preferably 24 or less, more preferably 18 or less, or 14 or less, and still more preferably 10 or less. This number of the carbon atom does not include the number of the carbon atom in the substituent. Illustrative examples of the aromatic ring may include: a monocyclic aromatic ring such as a benzene ring, a furan ring, a thiophene ring, a pyrrole ring, a pyrazole ring, an oxazole ring, an isoxazole ring, a thiazole ring, an imidazole ring, a pyridine ring, a pyridazine ring, a pyrimidine ring, and a pyrazine ring; a fused polycyclic aromatic ring formed of 2 or more monocyclic aromatic rings fused, such as a naphthalene ring, an anthracene ring, a phenanthrene ring, a benzofuran ring, an isobenzofuran ring, an indole ring, an isoindole ring, a benzothiophene ring, a benzoimidazole ring, an indazole ring, a benzoxazole ring, a benzoisoxazole ring, a benzothiazole ring, a quinoline ring, an isoquinoline ring, a quinoxaline ring, an acridine ring, a quinazoline ring, a cynoline ring, and a phthalazine ring. Among these, as for the aromatic ring, a benzene ring, a naphthalene ring, and an anthracene ring are preferable, and a benzene ring and a naphthalene ring are especially preferable. In the present specification, the carbon atom that constitutes the aromatic ring is referred to as the "aromatic carbon".

Hereinafter, the present invention will be described in detail in line with preferable embodiments. Note that the present invention is not limited to the embodiments and examples described below; thus, the present invention may be carried out with any modification so far as such modification is not outside the claims or the equivalents thereof.

### <Active ester resin>

The active ester resin according to one embodiment of the present invention contains one or more of an α-methylbenzyl group per one molecule. The number of the α-methylbenzyl group that the active ester resin contains per one molecule is usually 1 or more, and may be 2 or more, 4 or more, 6 or more, or the like. The upper limit of the number of the α-methylbenzyl group that the active ester resin contains per one molecule is preferably 20 or less, more preferably 12 or less, and especially preferably 8 or less. When the active ester resin contains a combination of molecules having different numbers of the α-methylbenzyl group per one molecule, it is preferable that the average number of the α-methylbenzyl groups that the active ester resin contains per one molecule is within the range described above.

The active ester resin usually has an ester bond directly bonded to the aromatic ring. Since this ester bond is capable of reacting with a functional group such as an epoxy group to form a bond, this ester bond may be called an "active ester group". The "active ester group" includes not only an ester bond having an aromatic carbon-C(=O)-O-aromatic carbon structure, but also an ester bond having an aliphatic carbon-C(=O)-O-aromatic carbon structure as long as it can react with a functional group to form a bond.

By curing a resin composition containing a combination of the active ester resin according to the present embodiment and a crosslinkable resin such as an epoxy resin, a cured product having a low dielectric dissipation factor in a high temperature environment can be obtained. The inventor of the present invention presumes the mechanism, by which such advantageous effects can be obtained, as follows. However, the technical scope of the present invention is not restricted by the mechanism described below.

By the action of the α-methylbenzyl group, the molecular motion of the active ester resin is restricted. For example, when the α-methylbenzyl group is bonded to an aromatic ring, the rotation of this aromatic ring is restricted. In particular, due to the action of the methyl group included in the α-methylbenzyl group, the degree of restriction of molecular motion is significant. This restriction of the molecular motion of the active ester resin can effectively reduce the dielectric dissipation factor of the cured product in a high temperature environment.

According to the inventor's study, it was found that an active ester resin having a benzyl group instead of the α-methylbenzyl group cannot effectively reduce the dielectric dissipation factor in a high temperature environment as described above. Although the effect of the active ester resin containing the benzyl group has been experimentally verified in the past as described in Patent Literatures 1 to **4,** the effect of the active ester resin containing the α-methylbenzyl group has not been experimentally verified yet. Under the circumstances described above, the aforementioned effect by the active ester resin containing the α-methylbenzyl group has been first discovered by the inventor of the present invention, and this is industrially beneficial.

In addition, those conventional active ester resins have problems of a poor smear removability at the time when a via hole is formed in an insulating layer and of an easy separation (haloing) between the insulating layer and an inner layer board. In contrast, it is possible that a cured product of the resin composition containing the active ester resin according to the present embodiment in combination with a crosslinkable resin usually has an excellent smear removability. In addition, usually the cured product of the resin composition containing the active ester resin according to the present embodiment in combination with the crosslinkable resin is able to suppress haloing.

The active ester resin according to one embodiment of the present invention usually contains one or more, preferably two or more aromatic rings, in addition to the benzene ring included in the α-methylbenzyl group. And the α-methylbenzyl group is preferably bonded to a part or all of the aforementioned aromatic rings. Therefore, it is preferable that the active ester resin contains one, or 2 or more aromatic rings to which the α-methylbenzyl group is bonded. At this time, it is preferable that the α-methylbenzyl group is bonded directly to the aromatic carbon included in the aromatic ring.

The aromatic ring to which the α-methylbenzyl group is bonded may be selected from those described above, while an aromatic carbon ring is preferable. The aromatic ring to which the α-methylbenzyl group is bonded may be a monocyclic aromatic ring or a fused polycyclic aromatic ring. The number of the carbon atom in the aromatic ring to which the α-methylbenzyl group is bonded is preferably 6 or more, and is preferably 14 or less, and especially preferably 10 or less. The number of the carbon atom in the aromatic ring does not include the number of the carbon atom in the α-methylbenzyl group. Illustrative examples of the preferable aromatic ring to which the α-methylbenzyl group is bonded may include a benzene ring, a naphthalene ring, and an anthracene ring. The aromatic ring to which the α-methylbenzyl group is bonded may be one type, or two or more types.

The aromatic ring to which the α-methylbenzyl group is bonded may be bonded to one, or two or more other aromatic rings directly via a single bond or indirectly via an organic group. Such an organic group may be, for example, an organic group composed of one or more (for example, 1 to 3000, 1 to 1000, 1 to 100, and 1 to 50) skeletal atoms selected from a carbon atom, an oxygen atom, a nitrogen atom, and a sulfur atom. This organic group may have a halogen atom in addition to or in place of a hydrogen atom as a non-skeletal atom. This organic group may contain a linear structure, a branched chain structure, and/or a cyclic structure. The organic group may be an organic group containing an aromatic ring or an organic group not containing an aromatic ring.

For example, the active ester resin may contain a polyaryleneoxy structure, and the α-methylbenzyl group may be bonded to a part or all of the arylene groups included in the polyaryleneoxy structure. However, from the viewpoint of eminently exhibiting the advantageous effects of the present invention, it is preferable that the α-methylbenzyl group is not bonded to the arylene group included in the polyaryleneoxy structure, and more preferable that the active ester resin does not contain a polyaryleneoxy structure.

It is preferable that the α-methylbenzyl group is bonded in a specific range of numbers on average to one aromatic ring to which the α-methylbenzyl group is bonded. Here, the average number of the α-methylbenzyl group bonded to one aromatic ring to which the α-methylbenzyl group is bonded may be referred to as the "average number of the bonds". The average number of the bonds described above is obtained by dividing the number of the α-methylbenzyl group bonded to an aromatic ring by the number of the aromatic ring bonded to the α-methylbenzyl group. Usually, the specific range of the average number of the bonds is usually 1 or more, and is preferably 6 or less, more preferably 4 or less, still more preferably 3 or less, and especially preferably 2 or less.

It is preferable that the active ester group is bonded to the aromatic ring to which the α-methylbenzyl group is bonded. Therefore, it is preferable that a carbonyloxy group or an oxycarbonyl group is bonded to the aromatic ring to which the α-methylbenzyl group is bonded. In particular, it is especially preferable that the oxygen atom of the active ester group is bonded to the aromatic ring to which the α-methylbenzyl group is bonded.

The content of the α-methylbenzyl group contained in the active ester resin is preferably 1% by mass or more, more preferably 5% by mass or more, and especially preferably 10% by mass or more, and is preferably 60% by mass or less, more preferably 50% by mass or less, and especially preferably 45% by mass or less. The content of the α-methylbenzyl group may be adjusted to an intended range by a person ordinarily skilled in the art by controlling the types of raw materials and the reaction ratio of them in the production method to be described later.

Examples of a preferable active ester resin may include an active ester resin including a partial structure represented by the following formula (I). Therefore, examples of the preferable active ester resin may include the active ester resin that includes the partial structure represented by the following formula (I) and contains one or more α-methylbenzyl groups per one molecule.

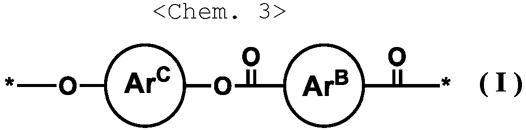

(In the formula (I),
a group Ar^{B} each independently represents a divalent organic group containing at least one aromatic ring,
a group Ar^{C} each independently represents a divalent organic group containing at least one aromatic ring, and
* represents a bond.)

### -Explanation of the organic group Ar^{B}-

In the formula (I), the group Ar^{B} each independently represents a divalent organic group containing at least one aromatic ring. However, the aromatic ring included in the organic group Ar^{B} does not include the benzene ring included in the α-methylbenzyl group. The aromatic ring included in the organic group Ar^{B} may be any of a monocyclic aromatic ring and a fused polycyclic aromatic ring having two or more monocyclic aromatic rings fused together, as described before. The aromatic ring may be any of an aromatic carbon ring and an aromatic heterocyclic ring.

From the viewpoint of eminently obtaining the advantageous effects of the present invention, it is preferable that the aromatic ring included in the organic group Ar^{B} is an aromatic carbon ring. The number of the carbon atom in the aromatic carbon ring is preferably 6 to 14, more preferably 6 to 10. Therefore, in one preferable embodiment, the aromatic ring included in the organic group Ar^{B} is an aromatic carbon ring having 6 to 14 carbon atoms.

The aromatic ring included in the organic group Ar^{B} may have a substituent. Such substituents have already been described. Among them, from the viewpoint of eminently obtaining the advantageous effects of the present invention, one or more groups selected from a halogen atom, a hydrocarbon group, and an alkoxy group are preferable, and one or more groups selected from a hydrocarbon group and an alkoxy group are more preferable. In particular, one or more groups selected from a hydrocarbon group having 1 to 10 carbon atoms and an alkoxy group having 1 to 10 carbon atoms are more preferable, and one or more groups selected from an alkyl group having 1 to 6 carbon atoms, an aryl group having 6 to 10 carbon atoms, an arylalkyl group having 7 to 10 carbon atoms, an unsaturated aliphatic hydrocarbon group having 2 to 6 carbon atoms, and an alkoxy group having 1 to 6 carbon atoms are more preferable, and an aryl group having 6 to 10 carbon atoms is especially preferable. When the aromatic ring included in the organic group Ar^{B} has an unsaturated aliphatic hydrocarbon group as the substituent, the unsaturated aliphatic hydrocarbon group is preferably an alkenyl group or an alkynyl group, more preferably an alkenyl group, and still more preferably an allyl group.

The organic group Ar^{B} may contain the α-methylbenzyl group. Therefore, the hydrogen atom of the organic group Ar^{B} may not be substituted with the α-methylbenzyl group, and a part or all of the hydrogen atoms of the organic group Ar^{B} may be substituted with the α-methylbenzyl group. When the organic group Ar^{B} contains the α-methylbenzyl group, it is preferable that the α-methylbenzyl group is bonded to the aromatic ring included in the organic group Ar^{B}. Therefore, it is preferable that a part or all of the hydrogen atoms of the aromatic ring included in the organic group Ar^{B} are substituted with the α-methylbenzyl group.

Only one, or two or more α-methylbenzyl groups may be bonded to the aromatic ring included in the organic group Ar^{B}. The number of the α-methylbenzyl group bonded to one aromatic ring included in the organic group Ar^{B} is usually one or more, preferably 6 or less, more preferably 4 or less, and especially preferably 3 or less.

To the aromatic ring that is included in the organic group Ar^{B} and bonded to the α-methylbenzyl group, the active ester group is preferably bonded. Therefore, it is preferable that the aromatic ring that is included in the organic group Ar^{B} and bonded to the α-methylbenzyl group is bonded to the carbonyl group that is bonded to the organic group Ar^{B} in the formula (I).

A preferable example of the organic group Ar^{B} may include an arylene group to which the α-methylbenzyl group may be bonded and that may have a substituent. The number of the carbon atom in the arylene group in the organic group Ar^{B} is preferably 6 to 18, more preferably 6 to 14, and still more preferably 6 to 10. This number of the carbon atom does not include the number of the carbon atom in the α-methylbenzyl group and in the substituent. The organic group Ar^{B} is preferably a phenylene group to which the α-methylbenzyl group may be bonded and that may have a substituent, or a naphthylene group to which the α-methylbenzyl group may be bonded and that may have a substituent. Moreover, it is especially preferable that the organic group Ar^{B} is a phenylene group to which the α-methylbenzyl group may be bonded and that may have a substituent.

### -Explanation of the organic group Ar^{C}-

In the formula (I), the group Ar^{C} each independently represents a divalent organic group containing at least one aromatic ring. However, the aromatic ring included in the organic group Ar^{C} does not include the benzene ring included in the α-methylbenzyl group. The aromatic ring included in the organic group Ar^{C} may be any of a monocyclic aromatic ring and a fused polycyclic aromatic ring consisting of two or more monocyclic aromatic rings fused together, as described before. The aromatic ring may be any of an aromatic carbon ring and an aromatic heterocyclic ring.

From the viewpoint of eminently obtaining the advantageous effects of the present invention, it is preferable that the organic group Ar^{C} contains, as the aromatic ring, two or more monocyclic aromatic rings or at least one fused polycyclic aromatic ring. The monocyclic aromatic ring and the fused polycyclic aromatic ring have already been described. Therefore, in one preferable embodiment, the organic group Ar^{C} each independently represents a divalent organic group containing two or more monocyclic aromatic rings or a divalent organic group containing at least one fused polycyclic aromatic ring.

From the viewpoint of eminently obtaining the advantageous effects of the present invention, it is preferable that the aromatic ring included in the organic group Ar^{C} is an aromatic carbon ring. The number of the carbon atom in the aromatic carbon ring is preferably 6 to 14, and more preferably 6 to 10. Therefore, in one preferable embodiment, the aromatic ring included in the organic group Ar^{C} is an aromatic carbon ring having 6 to 14 carbon atoms.

Among them, from the viewpoint of eminently obtaining the advantageous effects of the present invention, it is preferable that the organic group Ar^{C} represents a divalent organic group containing two or more monocyclic aromatic carbon rings or a divalent organic group containing at least one fused polycyclic aromatic carbon ring. Here, the number of the carbon atom in one monocyclic aromatic carbon ring is preferably 6 (i.e., benzene ring). The number of the carbon atom in one fused polycyclic aromatic carbon ring is preferably 10 to 14 (for example, a naphthalene ring and an anthracene ring), and more preferably 10.

The aromatic ring included in the organic group Ar^{C} may have a substituent. These substituents have already been described. From the viewpoint of eminently obtaining the advantageous effects of the present invention, the substituent that the aromatic ring included in the organic group Ar^{C} may have is selected preferably from the same range as the substituent that the aromatic ring included in the organic group Ar^{B} may have.

The organic group Ar^{C} is not particularly restricted as long as it contains at least one aforementioned aromatic ring; and it is, as described before, the group containing at least a carbon atom as the skeletal atom, but preferably may be a divalent group composed of one or more (preferably 1 to 100, 1 to 50, or 1 to 30) skeletal atoms selected from a carbon atom, an oxygen atom, a nitrogen atom, and a sulfur atom. In particular, from the viewpoint of eminently obtaining the advantageous effects of the present invention, it is especially preferable that the organic group Ar^{C} contains only a carbon atom as the skeletal atom.

Therefore, in one especially preferable embodiment, the organic group Ar^{C} represents a divalent group containing two or more monocyclic aromatic carbon rings that may have a substituent and contain only a carbon atom as the skeletal atom, or a divalent group containing at least one fused polycyclic aromatic carbon ring that may have a substituent and contain only a carbon atom as the skeletal atom. With regard to this point, the substituent is one or more groups selected from an alkyl group having 1 to 6 carbon atoms, an aryl group having 6 to 10 carbon atoms, an arylalkyl group having 7 to 10 carbon atoms, an unsaturated aliphatic hydrocarbon group having 2 to 6 carbon atoms, and an alkoxy group having 1 to 6 carbon atoms. Preferable values and ranges for the number of the carbon atom in one monocyclic aromatic carbon ring and one fused polycyclic aromatic carbon ring have already been described. The preferable range of the number of the skeletal atom has already been described; this is especially preferably in the range of 10 to 50, or 10 to 30.

From the viewpoint of eminently obtaining the advantageous effects of the present invention, it is preferable that the oxygen atom bonded to the organic group Ar^{C} in the formula (I) is bonded to the aromatic carbon of the organic group Ar^{C}, i.e., to the carbon atom that constitutes the aromatic ring described above.

The organic group Ar^{C} may contain the α-methylbenzyl group. Therefore, the hydrogen atom of the organic group Ar^{C} may not be substituted with the α-methylbenzyl group, and a part or all of the hydrogen atoms of the organic group Ar^{C} may be substituted with the α-methylbenzyl group. From the viewpoint of eminently obtaining the advantageous effects of the present invention, it is preferable that the organic group Ar^{C} contains the α-methylbenzyl group.

When the organic group Ar^{C} contains the α-methylbenzyl group, it is preferable that the α-methylbenzyl group is bonded to the aromatic ring included in the organic group Ar^{C}. Therefore, it is preferable that a part or all of the hydrogen atoms of the aromatic ring included in the organic group Ar^{C} are substituted with the α-methylbenzyl group.

Only one, or two or more α-methylbenzyl groups may be bonded to the aromatic ring included in the organic group Ar^{C}. The number of the α-methylbenzyl group bonded to one aromatic ring included in the organic group Ar^{C} is usually one or more, preferably 6 or less, more preferably 4 or less, and especially preferably 3 or less.

To the aromatic ring that is included in the organic group Ar^{C} and bonded to the α-methylbenzyl group, the active ester group is preferably bonded. Therefore, it is preferable that the aromatic ring that is included in the organic group Ar^{C} and bonded to the α-methylbenzyl group is bonded to the oxygen atom that is bonded to the organic group Ar^{C} in the formula (I).

Preferable examples of the organic group Ar^{C} may include the groups represented by the following formulas (C-1), (C-2), or (C-3).

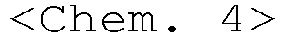

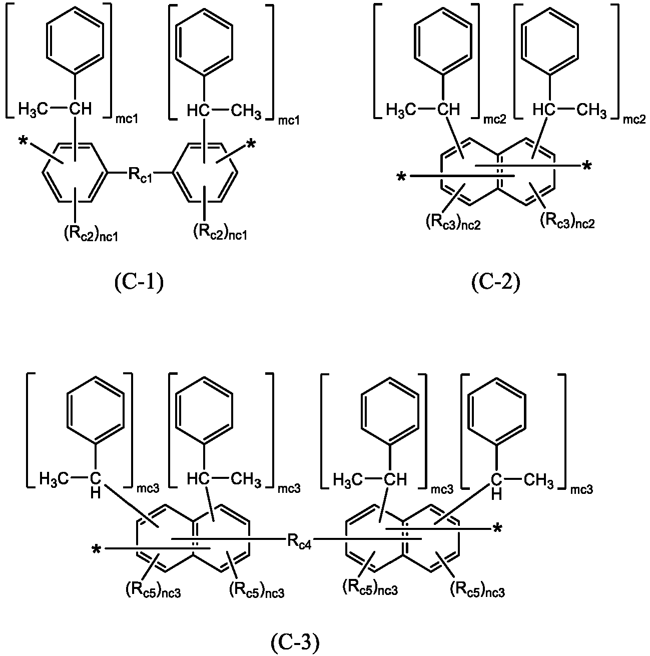

(In the formulas (C-1), (C-2), and (C-3),
R_{c1} and R_{c4} each independently represent a single bond, or a divalent linking group selected from the group consisting of a divalent hydrocarbon group having 1 to 10 carbon atoms that may have a substituent, an oxygen atom, a sulfonyl group, a carbonyl group, a carbonate group, and a combination of these groups,
R_{c2}, R_{c3}, and R_{c5} each independently represent a substituent,
mc1, mc2 and mc3 each independently represent the number 0 to 4,
nc1, nc2, and nc3 each independently represent the number of 0 to 4, and
* represents a bond.
Here, mc1 + nc1 is 0 or more and 4 or less; mc2 + nc2 is 0 or more and 4 or less; and mc3 + nc3 is 0 or more and 4 or less.)

In the formula (C-1), two benzene rings are explicitly illustrated in addition to the benzene ring included in the α-methylbenzyl group. These two benzene rings correspond to the "aromatic ring" described before for the organic group Ar^{C}. That is, the organic group Ar^{C} represented by the formula (C-1) is a divalent organic group containing at least two benzene rings. Preferable examples of the substituent R_{c2} have already been described as the substituent that the aromatic ring included in the organic group Ar^{C} may have; among them, preferable are one or more groups selected from an alkyl group having 1 to 6 carbon atoms, an aryl group having 6 to 10 carbon atoms, an arylalkyl group having 7 to 10 carbon atoms, an unsaturated aliphatic hydrocarbon group having 2 to 6 carbon atoms, and an alkoxy group having 1 to 6 carbon atoms.

In the formula (C-1), mc1 each independently represents the number of 0 to 4, preferably 1 to 3, and more preferably 1 to 2.

In the formula (C-1), nc1 each independently represents the number of 0 to 4, preferably 0 to 3, more preferably 0 to 2, and still more preferably 0 or 1.

However, mc1 + nc1 is 0 or more and 4 or less.

In the formula (C-1), R_{c1} represents a single bond or a divalent linking group selected from the group consisting of a divalent hydrocarbon group having 1 to 10 carbon atoms that may have a substituent, an oxygen atom, a sulfonyl group, a carbonyl group, a carbonate group, and a combination of these groups. The number of the carbon atom in the divalent linking group represented by R_{c1} is preferably 1 to 30, and more preferably 1 to 20, or 1 to 15.

Examples of the divalent hydrocarbon group of R_{c1} may include a divalent aliphatic hydrocarbon group and a divalent aromatic hydrocarbon group. Illustrative examples thereof may include an alkylene group, a cycloalkylene group, an alkenylene group, a cycloalkenylene group, an alkapolyenylene group (the number of the double bond is preferably 2 to 10, more preferably 2 to 6, still more preferably 2 to 4, and far still more preferably 2), and an arylene group; among them, an alkylene group, a cycloalkylene group, an alkenylene group, a cycloalkenylene group, and an arylene group are preferable, and an alkylene group, a cycloalkylene group, and an arylene group are more preferable.

The alkylene group of R_{c1} may be any of linear and branched, and the number of carbon atom thereof is more preferably 1 to 6, and still more preferably 1 to 4, or 1 to 3. This number of the carbon atom does not include the number of the carbon atom in the substituent. Illustrative examples of the alkylene group may include a methylene group, an ethylene group, a propylene group, a butylene group, a pentylene group, and a hexylene group.

The number of the carbon atom in the cycloalkylene group of R_{c1} is more preferably 3 to 10, 4 to 10, or 6 to 10. This number of the carbon atom does not include the number of the carbon atom in the substituent. Illustrative examples of the cycloalkylene group may include a cyclopropylene group, a cyclobutylene group, a cyclopentylene group, a cyclohexylene group, a decahydronaphthalene group, a norbornanylene group, a dicyclopentanylene group, and an adamantanylene group.

The alkenylene group of R_{c1} may be any of linear and branched, and the number of the carbon atom thereof is more preferably 2 to 6, and still more preferably 2 to 4. This number of the carbon atom does not include the number of the carbon atom in the substituent. Illustrative examples of the alkenylene group may include an ethenylene group, a propenylene group, a butenylene group, a pentenylene group, and a hexenylene group.

The number of the carbon atom in the cycloalkenylene group of R_{c1} is more preferably 3 to 10, 4 to 10, or 6 to 10. This number of the carbon atom does not include the number of the carbon atom in the substituent. Illustrative examples of the cycloalkenylene group may include a cyclopropenylene group, a cyclobutenylene group, a cyclopentenylene group, a cyclohexenylene group, and a norbornenylene group.

The number of the carbon atom in the arylene group of R_{c1} is more preferably 6 to 10. This number of the carbon atom does not include the number of the carbon atom in the substituent. Illustrative examples of the arylene group may include a phenylene group, a naphthylene group, and an indandiyl group.

From the viewpoint of eminently obtaining the advantageous effects of the present invention, it is preferable that the divalent linking group represented by R_{c1} is a divalent hydrocarbon group having 1 to 10 carbon atoms that may have a substituent, or a divalent group composed of a combination of them. Among these, more preferable are an alkylene group having 1 to 6 carbon atoms that may have a substituent, a cycloalkylene group having 6 to 10 carbon atoms that may have a substituent, an alkenylene group having 2 to 6 carbon atoms that may have a substituent, a cycloalkenylene group having 6 to 10 carbon atoms that may have a substituent, an arylene group having 6 to 10 carbon atoms that may have a substituent, or a combination of these groups. Still more preferable are an alkylene group having 1 to 6 carbon atoms that may have a substituent, a cycloalkylene group having 6 to 10 carbon atoms that may have a substituent, an arylene group having 6 to 10 carbon atoms that may have a substituent, or a combination of these groups. Especially preferable are an alkylene group having 1 to 6 carbon atoms that may have a substituent, an arylene group having 6 to 10 carbon atoms that may have a substituent, or a combination of these groups. Preferable examples of the divalent group formed of the combination of the hydrocarbon groups may include a C₁ to C₆ alkylene-C₆ to C₁₀ arylene-C₁ to C₆ alkylene group, and a C₁ to C₆ alkylene-C₆ to C₁₀ arylene-C₆ to C₁₀ arylene-C₁ to C₆ alkylene group. In the divalent group formed of the combinations, the preferable range of the number of the carbon atoms in the constituent alkylene and arylene groups and the matter that they may have a substituent have already been described.

The substituents that the divalent hydrocarbon group of R_{c1} may contain have already been described. Among those substituents, one or more substituents selected from an alkyl group and an aryl group are preferable, and one or more substituents selected from an alkyl group having 1 to 6 carbon atoms and an aryl group having 6 to 10 carbon atoms are more preferable.

From the viewpoint of eminently obtaining the advantageous effects of the present invention, especially preferable examples of the organic group Ar^{C} represented by the formula (C-1) will be described below.

In one preferable embodiment, in the formula (C-1),
R_{c1} represents a single bond, an alkylene group having 1 to 6 carbon atoms that may have a substituent, a cycloalkylene group having 6 to 10 carbon atoms that may have a substituent, an allylene group having 6 to 10 carbon atoms that may have a substituent, or a divalent group formed of a combination of these groups,
R_{c2} each independently represents an alkyl group having 1 to 6 carbon atoms, an aryl group having 6 to 10 carbon atoms, an arylalkyl group having 7 to 10 carbon atoms, an unsaturated aliphatic hydrocarbon group having 2 to 6 carbon atoms, or an alkoxy group having 1 to 6 carbon atoms,
mc1 each independently represents 1 or 2, and
nc1 each independently represents 0 or 1.

In one more preferable embodiment, in the formula (C-1),
R_{c1} represents a single bond, an alkylene group having 1 to 3 carbon atoms that may have a substituent, a cycloalkylene group having 6 to 10 carbon atoms that may have a substituent, a (C₁ to C₃ alkylene-C₆ to C₁₀ arylene-C₁ to C₃ alkylene) group that may have a substituent, or a (C₁ to C₃ alkylene-C₆ to C₁₀ arylene-C₆ to C₁₀ arylene-C₁ to C₃ alkylene) group that may have a substituent,
R_{c2} each independently represents an alkyl group having 1 to 3 carbon atoms, an aryl group having 6 to 10 carbon atoms, an arylalkyl group having 7 to 10 carbon atoms, an allyl group, or an alkoxy group having 1 to 3 carbon atoms,
mc1 each independently represents 1 or 2, and
nc1 each independently represents 0 or 1.

In one especially preferable embodiment, in the formula (C-1),
R_{c1} represents a single bond, an alkylene group having 1 to 3 carbon atoms that may have a substituent, a (C₁ to C₃ alkylene-C₆ to C₁₀ arylene-C₁ to C₃ alkylene) group that may have a substituent, or a (C₁ to C₃ alkylene-C₆ to C₁₀ arylene-C₆ to C₁₀ arylene-C₁ to C₃ alkylene) group that may have a substituent,
R_{c2} each independently represents an alkyl group having 1 to 3 carbon atoms, an aryl group having 6 to 10 carbon atoms, an arylalkyl group having 7 to 10 carbon atoms, an allyl group, or an alkoxy group having 1 to 3 carbon atoms,
mc1 each independently represents 1 or 2, and
nc1 each independently represents 0 or 1.

In the formula (C-2), one naphthalene ring is explicitly illustrated. This one naphthalene ring corresponds to the "aromatic ring" described before for the organic group Ar^{C}. That is, the organic group Ar^{C} represented by the formula (C-2) is a divalent organic group containing at least one naphthalene ring. Preferable examples of the substituent R_{c3} have already been described as the substituent that the aromatic ring included in the organic group Ar^{C} may have; among them, preferable are one or more groups selected from an alkyl group having 1 to 6 carbon atoms, an aryl group having 6 to 10 carbon atoms, an arylalkyl group having 7 to 10 carbon atoms, an unsaturated aliphatic hydrocarbon group having 2 to 6 carbon atoms, and an alkoxy group having 1 to 6 carbon atoms.

In the formula (C-2), mc2 each independently represents the number of 0 to 4, preferably 1 to 3, and more preferably 1 to 2.

In the formula (C-2), nc2 each independently represents the number of 0 to 4, preferably 0 to 3, more preferably 0 to 2, and still more preferably 0 or 1.

However, mc2 + nc2 is 0 or more and 4 or less.

From the viewpoint of eminently obtaining the intended effects of the present invention, especially preferable examples of the organic group Ar^{C} represented by the formula (C-2) will be described below.

In one preferable embodiment, in the formula (C-2),
R_{c3} each independently represents an alkyl group having 1 to 6 carbon atoms, an aryl group having 6 to 10 carbon atoms, an arylalkyl group having 7 to 10 carbon atoms, an unsaturated aliphatic hydrocarbon group having 2 to 6 carbon atoms, or an alkoxy group having 1 to 6 carbon atoms,
mc2 each independently represents 1 or 2, and
nc2 each independently represents 0 or 1.

In one more preferable embodiment, in the formula (C-2),
R_{c3} each independently represents an alkyl group having 1 to 3 carbon atoms, an aryl group having 6 to 10 carbon atoms, an arylalkyl group having 7 to 10 carbon atoms, an allyl group, or an alkoxy group having 1 to 3 carbon atoms,
mc2 each independently represents 1 or 2, and
nc2 each independently represents 0 or 1.

In the formula (C-3), two naphthalene rings are explicitly illustrated. These two naphthalene rings correspond to the "aromatic rings" described before for the organic group Ar^{C}. That is, the organic group Ar^{C} represented by the formula (C-3) is a divalent organic group containing at least two naphthalene rings. Preferable examples of the substituent R_{c5} have already been described as the substituent that the aromatic ring included in the organic group Ar^{C} may have; among them, preferable are one or more groups selected from an alkyl group having 1 to 6 carbon atoms, an aryl group having 6 to 10 carbon atoms, an arylalkyl group having 7 to 10 carbon atoms, an unsaturated aliphatic hydrocarbon group having 2 to 6 carbon atoms, and an alkoxy group having 1 to 6 carbon atoms.

In the formula (C-3), mc3 each independently represents the number of 0 to 4, preferably 1 to 3, and more preferably 1 to 2.

In the formula (C-3), nc3 each independently represents the number of 0 to 4, preferably 0 to 3, more preferably 0 to 2, and still more preferably 0 or 1.

However, mc3 + nc3 is 0 or more and 4 or less.

In the formula (C-3), R_{c4} represents a single bond or a divalent linking group selected from the group consisting of a divalent hydrocarbon group having 1 to 10 carbon atoms that may have a substituent, an oxygen atom, a sulfonyl group, a carbonyl group, a carbonate group, and a combination of these groups. The number of the carbon atom in the divalent linking group represented by R_{c4} is preferably 1 to 20, and more preferably 1 to 10, or 1 to 6.

The divalent hydrocarbon group of R_{c4} is the same as the divalent hydrocarbon group of R_{c1} including preferable examples thereof, and among them, an alkylene group having 1 to 6 carbon atoms that may have a substituent, or a cycloalkylene group having 6 to 10 carbon atoms that may have a substituent is preferable. Preferable examples of the substituent are also the same as those of the divalent hydrocarbon group in R_{c1}.

From the viewpoint of eminently obtaining the intended effects of the present invention, especially preferable examples of the organic group Ar^{C} represented by the formula (C-3) will be described below.

In one preferable embodiment, in the formula (C-3),
R_{c4} represents a single bond, an alkylene group having 1 to 6 carbon atoms that may have a substituent, or a cycloalkylene group having 6 to 10 carbon atoms that may have a substituent,
R_{c5} each independently represent an alkyl group having 1 to 6 carbon atoms, an aryl group having 6 to 10 carbon atoms, an arylalkyl group having 7 to 10 carbon atoms, an unsaturated aliphatic hydrocarbon group having 2 to 6 carbon atoms, or an alkoxy group having 1 to 6 carbon atoms,
mc3 each independently represents 1 or 2, and
nc3 each independently represents 0 or 1.

In one more preferable embodiment, in the formula (C-3),
R_{c4} represents a single bond, or an alkylene group having 1 to 3 carbon atoms that may have a substituent,
R_{c5} each independently represents an alkyl group having 1 to 3 carbon atoms, an aryl group having 6 to 10 carbon atoms, an arylalkyl group having 7 to 10 carbon atoms, an allyl group, or an alkoxy group having 1 to 3 carbon atoms,
mc3 each independently represents 1 or 2, and
nc3 each independently represents 0 or 1.

Among those described above, from the viewpoint of eminently obtaining the advantageous effects of the present invention, it is preferable that the organic group Ar^{C} is a divalent hydrocarbon group containing at least one aromatic ring.

Preferable specific examples of the organic group Ar^{C} may include divalent groups represented by the following formulas (c-1) to (c-11). The divalent groups represented by the formulas (c-1) to formula (c-8) correspond to the organic group represented by the formula (C-1) described before, the divalent group represented by the formula (c-9) corresponds to the organic group represented by the formula (C-2) described before, and the divalent groups represented by the formula (c-10) and formula (c-11) correspond to the organic group represented by the formula (C-3) described before.

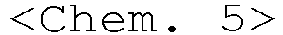

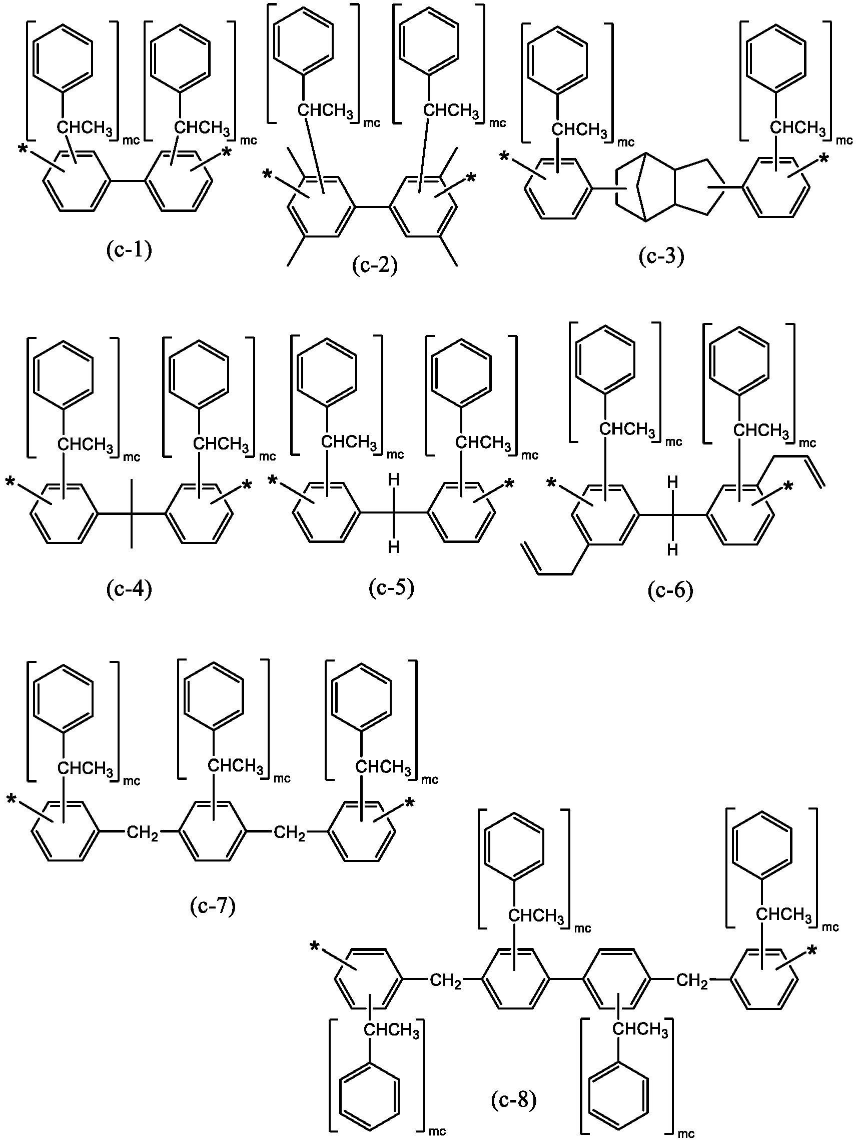

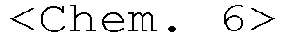

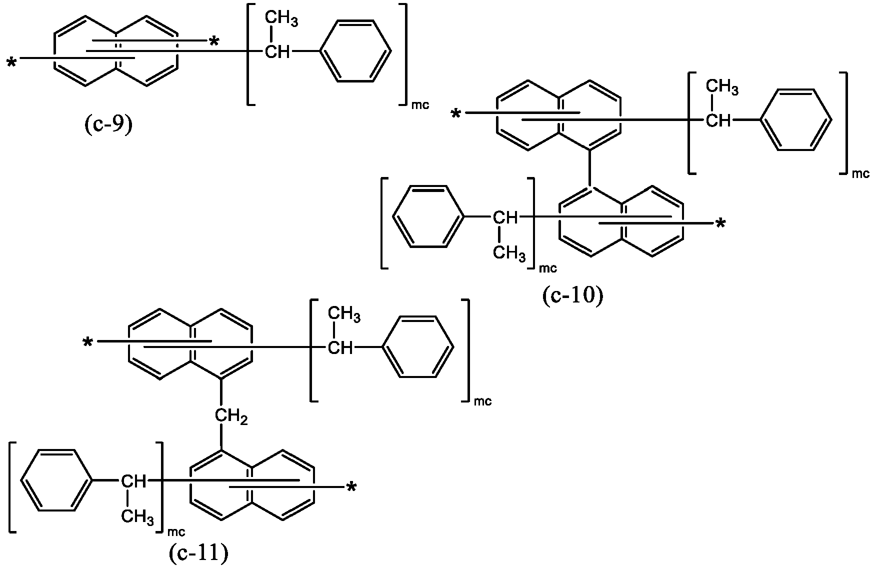

(In the formulas (c-1) to (c-11), mc represents 0, 1, or 2, and preferably 1 or 2. * represents a bond.)

A more preferable active ester resin is a resin represented by the following formula (II).

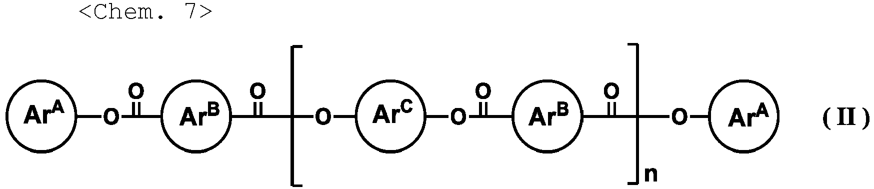

(In the formula (II),
a group Ar^{A} each independently represents a monovalent organic group containing at least one aromatic ring,
the group Ar^{B} each independently represents a divalent organic group containing at least one aromatic ring,
the group Ar^{C} each independently represents a divalent organic group containing at least one aromatic ring,
at least one organic group of the organic group Ar^{A}, the organic group Ar^{B}, and the organic group Ar^{C} contains the α-methylbenzyl group, and
n represents the number more than 0.)

In the formula (II), the group Ar^{B} each is independently the same as the group Ar^{B} in the formula (I). In the formula (II), the group Ar^{C} each is independently the same as the group Ar^{C} in the formula (I).

### -Explanation of the organic group Ar^{A}-

In the formula (II), the group Ar^{A} each independently represents a monovalent organic group containing at least one aromatic ring. However, the aromatic ring included in the organic group Ar^{A} does not include the benzene ring included in the α-methylbenzyl group. The aromatic ring included in the organic group Ar^{A} may be any of a monocyclic aromatic ring and a fused polycyclic aromatic ring consisting of two or more monocyclic aromatic rings fused together, as described before. The aromatic ring may be any of an aromatic carbon ring and an aromatic heterocyclic ring.

The organic group Ar^{A} may contain, as the aromatic ring, one, or two or more monocyclic aromatic rings, or at least one fused polycyclic aromatic ring. The monocyclic aromatic ring and the fused polycyclic aromatic ring have already been described. Therefore, in one embodiment, the organic group Ar^{A} may each independently represent a monovalent organic group containing one, or two or more monocyclic aromatic rings, or a monovalent organic group containing at least one fused polycyclic aromatic ring.

From the viewpoint of eminently obtaining the advantageous effects of the present invention, it is preferable that the aromatic ring included in the organic group Ar^{A} is an aromatic carbon ring. The number of the carbon atom in this aromatic carbon ring is preferably 6 to 14, and more preferably 6 to 10. Therefore, in one preferable embodiment, the aromatic ring included in the organic group Ar^{A} is an aromatic carbon ring having 6 to 14 carbon atoms.

Therefore, from the viewpoint of eminently obtaining the advantageous effects of the present invention, the organic group Ar^{A} represents a monovalent organic group containing a monocyclic aromatic carbon ring, or a monovalent organic group containing a fused polycyclic aromatic carbon ring. Here, the number of the carbon atom in one monocyclic aromatic carbon ring is preferably 6 (i.e., benzene ring). The number of the carbon atom in one fused polycyclic aromatic carbon ring is preferably 10 to 14 (for example, a naphthalene ring and an anthracene ring), more preferably 10.

The aromatic ring included in the organic group Ar^{A} may have a substituent. These substituents have already been described. From the viewpoint of eminently obtaining the advantageous effects of the present invention, it is preferable that the substituent that the aromatic ring included in the organic group Ar^{A} may have is selected from the same range as the substituent that the aromatic ring included in the organic group Ar^{B} may have.

The organic group Ar^{A} is not particularly restricted as long as it contains at least one aromatic ring, and is, as described before, the group containing at least a carbon atom as the skeleton atom, but preferably may be a monovalent group composed of one or more (preferably 1 to 100, 1 to 50, or 1 to 30) skeletal atoms selected from a carbon atom, an oxygen atom, a nitrogen atom, and a sulfur atom. Among them, from the viewpoint of eminently obtaining the advantageous effects of the present invention, it is especially preferable that the organic group Ar^{A} contains only a carbon atom as the skeletal atom.

Therefore, in one especially preferable embodiment, the organic group Ar^{A} represents a monovalent group containing a monocyclic aromatic carbon ring that may have a substituent and contains only a carbon atom as the skeletal atom, or a monovalent group containing a fused polycyclic aromatic carbon ring that may have a substituent and contains only a carbon atom as the skeletal atom. With regard to this point, the substituent is one or more groups selected from an alkyl group having 1 to 6 carbon atoms, an aryl group having 6 to 10 carbon atoms, an arylalkyl group having 7 to 10 carbon atoms, an unsaturated aliphatic hydrocarbon group having 2 to 6 carbon atoms, and an alkoxy group having 1 to 6 carbon atoms. Preferable values and ranges for the number of the carbon atom in one monocyclic aromatic carbon ring and one fused polycyclic aromatic carbon ring have already been described. The preferable range of the number of the skeletal atom has already been described; this is especially preferably in the range of 10 to 50, or 10 to 30.

From the viewpoint of eminently obtaining the advantageous effects of the present invention, it is preferable that the oxygen atom bonded to the organic group Ar^{A} in the formula (II) is bonded to the aromatic carbon, i.e., the carbon atom constituting the aromatic ring described above, of the organic group Ar^{A}.

In the formula (II), at least one organic group of the organic group Ar^{A}, the organic group Ar^{B}, and the organic group Ar^{C} contains the α-methylbenzyl group. Therefore, the organic group Ar^{A} may contain the α-methylbenzyl group. Thus, the hydrogen atom of the organic group Ar^{A} is not necessarily substituted with the α-methylbenzyl group, and a part or all of the hydrogen atoms of the organic group Ar^{A} may be substituted with the α-methylbenzyl group. When the organic group Ar^{A} contains the α-methylbenzyl group, it is preferable that the α-methylbenzyl group is bonded to the aromatic ring included in the organic group Ar^{A}. Therefore, it is preferable that a part or all of the hydrogen atoms of the aromatic ring included in the organic group Ar^{A} are substituted with the α-methylbenzyl group.

Only one, or two or more α-methylbenzyl groups may be bonded to the aromatic ring that is included in the organic group Ar^{A}. The number of the α-methylbenzyl group bonded to one aromatic ring included in the organic group Ar^{A} is usually one or more, preferably 6 or less, more preferably 4 or less, and especially preferably 3 or less.

To the aromatic ring that is included in the organic group Ar^{A} and bonded to the α-methylbenzyl group, the active ester group is preferably bonded. Therefore, it is preferable that the aromatic ring that is included in the organic group Ar^{A} and bonded to the α-methylbenzyl group is bonded to the oxygen atom that is bonded to the organic group Ar^{A} in the formula (II).

Preferable examples of the organic group Ar^{A} may include an aryl group to which the α-methylbenzyl group may be bonded and that may have a substituent; among them, a phenyl group to which the α-methylbenzyl group may be bonded and that may have a substituent, and a naphthyl group to which the α-methylbenzyl group may be bonded and that may have a substituent are preferable.

Especially preferable specific examples of the organic group Ar^{A} may include the organic groups represented by the following formulas (A-1) to (A-6).

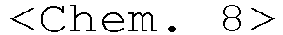

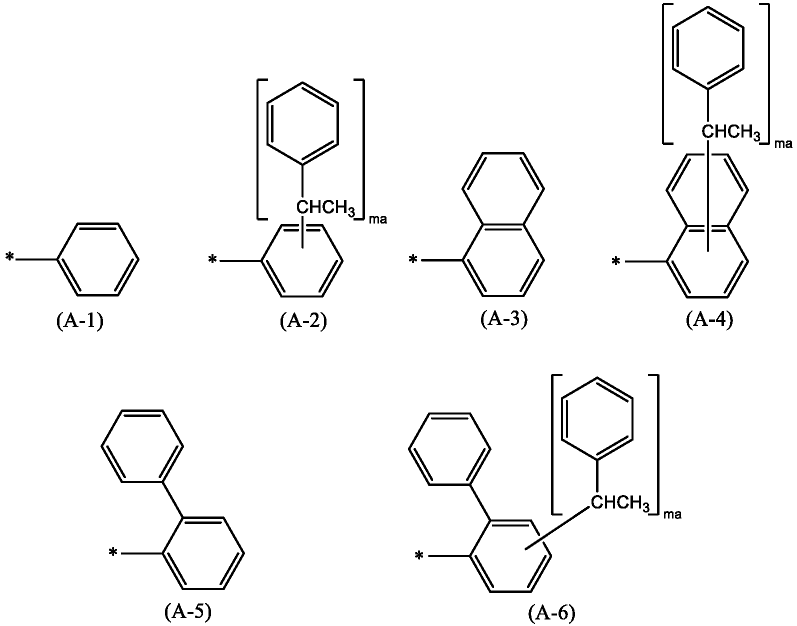

(In the formulas (A-1) to (A-6), ma each independently represent 1 or 2, and * represents a bond.)

### -Explanation of n-

In the formula (II), n represents the number more than 0. Here, n usually represents an average number of the repetition in the formula (II). The specific range of n is usually more than 0, preferably 0.2 or more, more preferably 0.3 or more, 0.5 or more, or 0.7 or more, and still more preferably 0.8 or more, 0.9 or more, or 1.0 or more. The upper limit of n is preferably 10 or less, more preferably 8 or less, 6 or less, 5 or less, 4 or less, or 3 or less. In one preferable embodiment, n in the formula (II) is the number satisfying 0<n≤3. Here, n may also be an integer; n may be, for example, 1, 2, or 3.

The range of the number-average molecular weight (Mn) of the active ester resin is preferably 10000 or less, more preferably 5000 or less, still more preferably 3000 or less, and especially preferably 2000 or less. The lower limit thereof is not particularly restricted as long as the active ester resin contains the α-methylbenzyl group; so, the lower limit may be, for example, 400 or more, or 500 or more. The number-average molecular weight of the resin may be measured in terms of polystyrene by a gel permeation chromatography (GPC) method.

The active ester equivalent of the active ester resin is preferably 150 g/eq. or more, more preferably 180 g/eq. or more, and especially preferably 200 g/eq. or more, and is preferably 5000 g/eq. or less, more preferably 2000 g/eq. or less, still more preferably 1000 g/eq. or less, and especially preferably 500 g/eq. or less. The active ester equivalent indicates the mass of the resin containing one equivalent amount of the active ester group.

### <Production method of the active ester resin>

Hereinafter, an example of the production method of the active ester resin according to one embodiment of the present invention will be described.

A first example of the production method of the active ester resin according to one embodiment of the present invention is the production method that includes an esterification step of reacting (X1) an aromatic polyvalent hydroxy compound with (X2) an aromatic carboxylic acid compound or an aromatic carboxylic acid halide compound. In the production method relating to this example, (X3) an aromatic monohydroxy compound may further react if necessary. The reaction of (X1) the aromatic polyvalent hydroxy compound, (X2) the aromatic carboxylic acid compound or the aromatic carboxylic acid halide compound, and (X3) the aromatic monohydroxy compound may proceed as a condensation reaction. In the production method according to the first example, the active ester resin according to the first embodiment of the present invention can be produced by using a compound containing the α-methylbenzyl group as one or more of (X1) the aromatic polyvalent hydroxy compound, (X2) the aromatic carboxylic acid compound or the aromatic carboxylic acid halide compound, and (X3) the aromatic monohydroxy compound.

(X1) The aromatic polyvalent hydroxy compound represents a compound containing an aromatic ring and two or more hydroxy groups. It is preferable that the hydroxy group is directly bonded to the aromatic ring. Illustrative examples of (X1) the aromatic polyvalent hydroxy compound may include bisphenol compounds such as biphenol, bisphenol A, bisphenol F, bisphenol S, bisphenol AF, allylated bisphenol A, fluorene bisphenol, terpene diphenol, tetrabromobisphenol A, 4,4'-biphenol, 2,2'-biphenol, 3,3',5,5'-tetramethyl-1,1'-biphenyl-4,4'-diol, a phenol aralkyl type bisphenol, and a dicyclopentadiene type bisphenol; tris phenol compounds such as tris-(4-hydroxyphenyl) methane; tetrakisphenol compounds such as 1,1,2,2-tetrakis(4-hydroxyphenyl)ethane; aromatic ring diol compounds such as hydroquinone, resorcinol, catechol, 1,4-naphthalenediol, 1,6-naphthalenediol, 2,3-naphthalenediol, and 2,6-naphthalenediol;and phenol polymers such as polycondensation products or polyadducts of a phenol compound (such as an alkyl-substituted or unsubstituted phenol, an alkyl-substituted or unsubstituted naphthol, an alkyl-substituted or unsubstituted hydroquinone, an alkyl-substituted or unsubstituted resorcinol, and an alkyl-substituted or unsubstituted naphthalenediol) and formaldehyde, acetaldehyde, benzaldehyde, p-hydroxybenzaldehyde, o-hydroxybenzaldehyde, furfural, p-hydroxyacetophenone, o-hydroxyacetophenone, dicyclopentadiene, 4,4'-bis(chloromethyl)-1,1'-biphenyl, 4,4'-bis(methoxymethyl)-1,1'-biphenyl, 1,4-bis(chloromethyl)benzene, 1,4-bis(methoxymethyl)benzene, or the like.

When a compound containing the α-methylbenzyl group is used as (X1) the aromatic polyvalent hydroxy compound, the production method of the active ester resin may include a modification step of introducing the α-methylbenzyl group into (X1) the aromatic polyvalent hydroxy compound. In the following explanation, (X1) the aromatic polyvalent hydroxy compound not containing the α-methylbenzyl group may be referred to as "(X1-2) an unmodified aromatic polyvalent hydroxy compound", and (X1) the aromatic polyvalent hydroxy compound containing the α-methylbenzyl group may be referred to as "(X1-1) a modified aromatic polyvalent hydroxy compound".

For example, by reacting (X1-2) the unmodified aromatic polyvalent hydroxy compound with styrene in the presence of an acid catalyst, the α-methylbenzyl group can be bonded to the aromatic ring of (X1-2) the unmodified aromatic polyvalent hydroxy compound to obtain (X1-1) the modified aromatic polyvalent hydroxy compound. Illustrative examples of the acid catalyst may include inorganic acids such as phosphoric acid, sulfuric acid, and hydrochloric acid; organic acids such as oxalic acid, benzenesulfonic acid, toluenesulfonic acid, methanesulfonic acid, and fluoromethanesulfonic acid; and Friedel-Crafts catalysts such as aluminum chloride, zinc chloride, stannic chloride, ferric chloride, and diethylsulfuric acid.

The amount of the acid catalyst used may be selected as appropriate in accordance with an intended amount of the α-methylbenzyl group to be introduced. For example, in the case of an inorganic acid or an organic acid, the amount of the acid catalyst may be 0.001 parts by mass to 10.0 parts by mass, and preferably 0.01 part by mass to 7.0 parts by mass, relative to 100 parts by mass of the total of (X1-2) the unmodified aromatic polyvalent hydroxy compound and styrene. In the case of the Friedel-Crafts catalyst, the amount of the acid catalyst may be 0.2 mole to 3.0 moles, and preferably 0.5 mole to 2.0 moles, relative to 1 mole of (X1-2) the unmodified aromatic polyvalent hydroxy compound.

The reaction of (X1-2) the unmodified aromatic polyvalent hydroxy compound with styrene may be carried out under a solvent-free condition or in the presence of a solvent. For example, the same solvent that is used for the condensation reaction to be described later may be used as the solvent. The reaction temperature is preferably 60°C to 180°C, and more preferably 80°C to 160°C. The reaction time is not particularly restricted, but it is preferably 1 hour to 100 hours.

After the reaction, the acid catalyst is removed by neutralization, washing with water, or decomposition, so that (X1-1) the modified aromatic polyvalent hydroxy compound can be separated by a general operation such as extraction or distillation. The neutralization and washing with water may be performed according to a usual method; therefore, for example, a basic substance such as sodium hydroxide, potassium hydroxide, sodium carbonate, ammonia, triethylenetetetramine, or aniline may be used as a neutralizing agent.

When a preferable active ester resin containing a partial structure represented by the formula (I) or a preferable active ester resin represented by the formula (II) is produced, a compound represented by the following formula (X1-C) is preferable as (X1) the polyvalent aromatic hydroxy compound. In the formula (X1-C), the group Ar^{C} is the same as the organic group Ar^{C} in the formula (I).

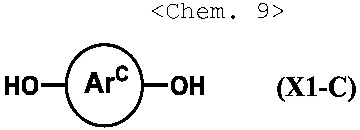

Among the components (X2), (X2-1) the aromatic carboxylic acid compound represents the compound containing an aromatic ring and a carboxyl group. (X2-1) The aromatic carboxylic acid compound may contain one carboxyl group per one molecule, but it is preferable to contain 2 or more carboxyl groups per one molecule, and especially preferable to contain 2 carboxyl groups per one molecule. It is preferable that the carboxyl group is bonded directly to the aromatic ring. Illustrative Examples of (X2-1) the aromatic carboxylic acid compound may include isophthalic acid that may have a substituent, terephthalic acid that may have a substituent, 2,6-naphthalene dicarboxylic acid that may have a substituent, 1,6-naphthalene dicarboxylic acid that may have a substituent, and 2,7-naphthalene dicarboxylic acid that may have a substituent. (X2-2) The aromatic carboxylic acid halide compound represents an acid halide compound of (X2-1) the aforementioned aromatic carboxylic acid compound. Illustrative examples of (X2-2) the aromatic carboxylic acid halide compound may include isophthalic acid chloride that may have a substituent, and terephthalic acid chloride that may have a substituent.

In the case of producing a preferable active ester resin containing a partial structure represented by the formula (I) or a preferable active ester resin represented by the formula (II), a compound represented by the following formula (X2-B1) is preferable as (X2-1) the aromatic carboxylic acid compound. As for (X2-2) the aromatic carboxylic acid halide compound, a compound represented by the following formula (X2-B2) is preferable. In the formula (X2-B1) and the formula (X2-B2), the group Ar^{B} is the same as the organic group Ar^{B} in the formula (I). In the formula (X2-B2), X represents a halogen atom.

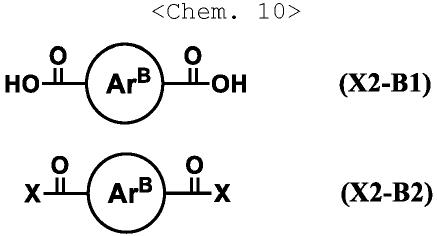

(X3) The aromatic monohydroxy compound represents a compound containing an aromatic ring and one hydroxy group. It is preferable that the hydroxy group is directly bonded to the aromatic ring. Illustrative examples of (X3) the aromatic monohydroxy compound may include phenol, cresol, p-t-butylphenol, 1-naphthol, 2-naphthol, ortho-phenylphenol, and para-phenylphenol.

When a compound containing the α-methylbenzyl group is used as (X3) the aromatic monohydroxy compound, the production method of the active ester resin may include a modification step of introducing the α-methylbenzyl group into (X3) the aromatic monohydroxy compound. The introduction of the α-methylbenzyl group into (X3) the aromatic monohydroxy compound may be performed by a method that includes, for example, performing the reaction of (X3) the aromatic monohydroxy compound with styrene in the presence of an acid catalyst. This reaction may be performed in the same way as the reaction of (X1-2) the unmodified aromatic polyvalent hydroxy compound with styrene.

When producing a preferable active ester resin represented by the formula (II), a compound represented by the following formula (X3-A) is preferable as (X3) the aromatic monohydroxy compound. In the formula (X3-A), the group Ar^{A} is the same as the organic group Ar^{A} in the formula (II).

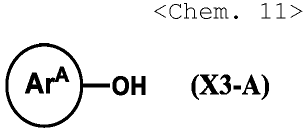

In the condensation reaction of the component (X1), the component (X2), and the component (X3), the condensation (esterification) proceeds between the component (X2) and the component (X1) and between the component (X2) and the component (X3). In such a reaction, the condensation degree between the component (X2) and the component (X1) can be controlled by changing the condition such as the amount ratio of the components, so that the structure of the resulting active ester resin (for example, the number of repetition n in the formula (II)) can be controlled.

The condensation reaction may proceed in a solvent-free system without using a solvent or in an organic solvent system using an organic solvent. Illustrative examples of the organic solvent used in the condensation reaction may include: ketone type solvents such as acetone, methyl ethyl ketone, methyl isobutyl ketone, and cyclohexanone; acetate ester type solvents such as ethyl acetate, butyl acetate, cellosolve acetate, propylene glycol monomethyl ether acetate, and carbitol acetate; carbitol type solvents such as cellosolve and butyl carbitol; aromatic hydrocarbon solvents such as toluene and xylene; and amide type solvents such as N,N-dimethylformamide, N,N-dimethylacetamide, and N-methyl-2-pyrrolidone. The organic solvent may be used singly or in a combination of two or more of them.

A base may be used in the condensation reaction. Illustrative examples of the base may include an alkali metal hydroxide such as sodium hydroxide (caustic soda) and potassium hydroxide; and tertiary amines such as triethylamine, pyridine, and N,N-dimethyl-4-aminopyridine (DMAP). The base may be used singly or as a combination of two or more of them.

A condensing agent and a phase transfer catalyst may also be used in the condensation reaction. Any conventionally known condensing agent and phase transfer catalyst used in an esterification reaction may be used.

The reaction temperature in the condensation reaction is not particularly restricted as long as the condensation reaction proceeds. For example, the reaction temperature may be set at 0°C to 80°C. The reaction time in the condensation reaction is not particularly restricted as long as an intended structure of the active ester resin is achieved. For example, the reaction time may be 30 minutes to 8 hours.

The active ester resin may be purified after the condensation reaction. For example, after the condensation reaction, a purification process such as water washing and microfiltration may be performed in order to remove a by-produced salt and excess amounts of the starting materials from the system. Specifically, after the condensation reaction, water whose amount is necessary to dissolve the by-produced salt is mixed, the mixture is left statically to separate the phases, and then the water phase is discarded. Further, if necessary, an acid is mixed for neutralization, and washing by water is repeated. The active ester resin may then be purified by microfiltration after dehydration step by a chemical or azeotrope to remove impurities, and if necessary, followed by distillation to remove an organic solvent to obtain the active ester resin. The organic solvent may be used as it is for the solvent of the resin composition without removing completely.

A second example of the production method of the active ester resin according to one embodiment of the present invention is the method that includes a esterification step of reacting (X1) the aromatic polyvalent hydroxy compound, (X2) the aromatic carboxylic acid compound or the aromatic carboxylic acid halide compound and, if necessary, further (X3) the aromatic monohydroxy compound to obtain a polyester resin as the condensation product, and a modification step of introducing the α-methylbenzyl group into the resulting polyester resin. The esterification step may be performed in the same way as that in the production method according to the first example. The modification step may be performed in the same way as the modification step of introducing the α-methylbenzyl group into (X1) the aromatic polyvalent hydroxy compound in the production method according to the first example. In a specific example, when the polyester resin reacts with styrene in the presence of an acid catalyst, a α-methylbenzyl group can be bonded onto the aromatic ring of the polyester resin to obtain the active ester resin.

Among the above-mentioned production methods, from the viewpoint of achieving a high yield, the production method according to the first example is preferable, and the production method using (X1) the aromatic polyvalent hydroxy compound containing the α-methylbenzyl group is more preferable. From the viewpoint of obtaining the active ester resin that can effectively improve the dielectric dissipation factor in a high temperature environment, the production method using (X3) the aromatic monohydroxy compound is especially preferable. Therefore, in one preferable embodiment, the production method of the active ester resin is preferably the method including a step of reacting (X1) the aromatic polyvalent hydroxy compound containing (X1-1) the modified aromatic polyvalent hydroxy compound that contains the α-methylbenzyl group, (X2) the aromatic carboxylic acid compound or the aromatic carboxylic acid halide compound, and (X3) the aromatic monohydroxy compound. When this preferable production method is used, the active ester resin can be produced as the condensation reaction product of (X1) the aromatic polyvalent hydroxy compound containing (X1-1) the modified aromatic polyvalent hydroxy compound that contains the α-methylbenzyl group, (X2) the aromatic carboxylic acid compound or the aromatic carboxylic acid halide compound, and(X3) the aromatic monohydroxy compound.

In combination with the crosslinkable resin, the active ester resin according to the present embodiment can bring about a cured product that exhibits excellent dielectric properties in a high temperature environment, thereby achieving the low transmission loss required in the 5G application. In addition, the cured product of the resin composition containing the active ester resin according to the present embodiment in combination with the crosslinkable resin is usually able to have an excellent smear removability. In addition, the cured product of the resin composition containing the active ester resin according to the present embodiment in combination with the crosslinkable resin is usually able to suppress haloing. Therefore, in one preferable embodiment, the aforementioned active ester resin can be suitably used as the resin crosslinking agent. The active ester resin, for example, may be provided as a resin crosslinking agent solely or as a solution resin crosslinking agent mixed with an appropriate solvent.

### <Resin composition>

A resin composition can be produced by using the active ester resin described above. The resin composition according to one embodiment of the present invention comprises the aformentioned active ester resin and a crosslinkable resin.

In the resin composition according to the present embodiment, the type of the crosslinkable resin is not particularly restricted as long as the crosslinkable resin is capable of forming cross-linkage in combination with the active ester resin. From the viewpoint of being able to bring about particularly excellent effects in combination with the active ester resin, it is preferable that the crosslinkable resin is one or more resins selected from the group consisting of a thermosetting resin and a radical polymerizable resin.

As for the thermosetting resin and radical polymerization resin, known resins used in forming the insulating layer of a printed wiring board or of a semiconductor chip package may be used. Hereinafter, the thermosetting resin and radical polymerizable resin that can be used as the crosslinkable resin will be described.

Illustrative examples of the thermosetting resin may include an epoxy resin, a benzocyclobutene resin, an epoxy acrylate resin, a urethane acrylate resin, a urethane resin, a cyanate resin, a polyimide resin, a benzoxazine resin, an unsaturated polyester resin, a phenol resin, a melamine resin, a silicone resin, and a phenoxy resin. The thermosetting resin may be used singly or in a combination of two or more of them. Among them, from the viewpoint of eminently obtaining the advantageous effects of the present invention in combination with the active ester resin, it is preferable that the crosslinkable resin includes an epoxy resin.

There is no particular restriction in type of the epoxy resin as long as it has one or more (preferably two or more) epoxy groups per one molecule. Illustrative examples of the epoxy resin may include a bisphenol A type epoxy resin, a bisphenol F type epoxy resin, a bisphenol S type epoxy resin, a bisphenol AF type epoxy resin, a phenol novolac type epoxy resin, a tert-butyl-catechol type epoxy resin, a naphthol type epoxy resin, a naphthalene type epoxy resin, a naphthylene ether type epoxy resin, a glycidylamine type epoxy resin, a glycidyl ester type epoxy resin, a cresol novolac type epoxy resin, a biphenyl type epoxy resin, a phenol aralkyl type epoxy resin, a biphenyl aralkyl type epoxy resin, a fluorene skeletal type epoxy resin, a dicyclopentadiene type epoxy resin, an anthracene type epoxy resin, a linear aliphatic epoxy resin, an epoxy resin having a butadiene structure, an alicyclic epoxy resin, a heterocyclic epoxy resin, an epoxy resin including a spiro ring, a cyclohexanedimethanol type epoxy resin, a trimethylol type epoxy resin, and a halogenated epoxy resin. The resin composition containing the active ester resin described above can bring about a cured product that exhibits excellent dielectric properties in a high temperature environment, regardless of the type of the epoxy resin.

The epoxy resin may be classified into an epoxy resin that is in the state of liquid at 20°C (hereinafter, this may be referred to as "liquid epoxy resin") and an epoxy resin that is in the state of solid at 20°C (hereinafter, this may be referred to as "solid epoxy resin"). The resin composition according to the present embodiment may contain, as the epoxy resin, only the liquid epoxy resin, or only the solid epoxy resin, or a combination of the liquid epoxy resin and the solid epoxy resin. When the liquid and solid epoxy resins are included in combination, the ratio of blending (liquid:solid) may be in the range of 20:1 to 1:20 by mass (preferably 10:1 to 1:10, more preferably 3:1 to 1:3).

The epoxy equivalent of the epoxy resin is preferably 50 g/eq. to 2000g/eq., more preferably 60 g/eq. to 1000g/eq., and still more preferably 80 g/eq. to 500 g/eq. The epoxy equivalent is the mass of the epoxy resin containing 1 equivalent of the epoxy group, and this can be measured in accordance with JIS K7236.

The weight-average molecular weight (Mw) of the thermosetting resin such as the epoxy resin is preferably 100 to 5,000, more preferably 250 to 3,000, and still more preferably 400 to 1,500. The weight-average molecular weight Mw of the resin can be measured in terms of polystyrene by a GPC method.

The type of the radical polymerizable resin is not particularly restricted as long as it has one or more (preferably two or more) radical polymerizable unsaturated groups per one molecule. Illustrative examples of the radical polymerizable resin may include resins having one or more radical polymerizable unsaturated groups selected from a maleimide group, a vinyl group, an allyl group, a styryl group, a vinyl phenyl group, an acryloyl group, a methacryloyl group, a fumaroyl group, and a maleoyl group. Among them, from the viewpoint of eminently obtaining the advantageous effects of the present invention, it is preferable that the crosslinkable resin includes one or more resins selected from a maleimide resin, a (meth)acrylic resin, and a styryl resin.

The type of the maleimide resin is not particularly restricted as long as it has one or more (preferably two or more) maleimide groups (2,5-dihydro-2,5-dioxo-1H-pyrrole-1-yl group) per one molecule. Illustrative examples of the maleimide resin may include: maleimide resins containing an aliphatic skeleton having 36 carbon atoms derived from a dimer diamine, such as "BMI-3000J", "BMI-5000", "BMI-1400", "BMI-1500", "BMI-1700", and "BMI-689" (all are manufactured by Designer Molecules Inc.); maleimide resins containing an indane skeleton described in Disclosure No. 2020-500211 in Journal of Technical Disclosure of the Japan Institute of Invention and Innovation; and maleimide resins containing an aromatic ring skeleton bonded directly to the nitrogen atom of the maleimide group, such as "MIR-3000-70MT" (manufactured by Nippon Kayaku Co., Ltd.), "BMI-4000" (manufactured by Daiwa Fine Chemicals Co., Ltd.), and "BMI-80" (manufactured by K-I Chemical Industry Co., Ltd.).

The type of the (meth)acrylic resin is not particularly restricted as long as it has one or more (preferably two or more) (meth)acryloyl groups per one molecule; thus, it may be a monomer or an oligomer. The term "(meth)acryloyl group" is a generic term for an acryloyl group and a methacryloyl group. Illustrative examples of the methacrylic resin may include (meth)acrylic resins such as "A-DOG" (manufactured by Shin-Nakamura Chemical Co., Ltd.), "DCP-A" (manufactured by Kyoeisha Chemical Co., Ltd.), and "NPDGA", "FM-400", "R-687", "THE-330", "PET-30", and "DPHA" (all being manufactured by Nippon Kayaku Co., Ltd.).

The type of the styryl resin is not particularly restricted as long as it has one or more (preferably two or more) styryl groups or vinyl phenyl groups per one molecule; this may be a monomer or an oligomer. Illustrative examples of the styryl resin may include styryl resins such as "OPE-2St", "OPE-2St 1200", and "OPE-2St 2200" (all being manufactured by Mitsubishi Gas Chemical Co., Ltd.).

The resin composition according to the present embodiment may contain, as the crosslinkable resin, only the thermosetting resin, only the radical polymerizable resin, or a combination of the thermosetting resin and the radical polymerizable resin.

In the resin composition according to the present embodiment, the mass ratio of active ester resin with respect to the crosslinkable resin (active ester resin/crosslinkable resin) may be 1 or more, preferably 1.05 or more, and more preferably 1.10 or more. The upper limit of the mass ratio (active ester resin/crosslinkable resin) may be, for example, 2 or less, 1.9 or less, or 1.8 or less.

The resin composition according to the present embodiment may further contain a crosslinking accelerator. By including the crosslinking accelerator, the crosslinking time and the crosslinking temperature can be efficiently controlled.

Illustrative examples of the crosslinking accelerator may include organic phosphine compounds such as "TPP", "TPP-K", "TPP-S", and "TPTP-S" (all being manufactured by Hokko Chemical Industry Co., Ltd.); imidazole compounds such as "Curezol 2MZ", "2E4MZ", "Cl1Z", "Cl1Z-CN", "Cl1Z-CNS", "Cl1Z-A", "2MZ-OK", "2MA-OK", and "2PHZ" (all being manufactured by Shikoku Chemical Industry Co., Ltd.); amine adduct compounds such as "Novacure" (manufactured by Asahi Kasei Chemicals Co., Ltd.) and "Fujicure" (manufactured by Fuji Kasei Co., Ltd.); amine compounds such as 1,8-diazabicyclo[5,4,0]undecene-7,4-dimethylaminopyridine, benzyldimethylamine, 2,4,6-tris(dimethylaminomethyl)phenol, and 4-dimethylaminopyridine; and organometallic complexes or organometallic salts of cobalt, copper, zinc, iron, nickel, manganese, tin, and the like.

When the resin composition according to the present embodiment contains the crosslinking accelerator, the amount of the crosslinking accelerator in the resin composition may be determined in accordance with the properties required for the resin composition. The amount of the crosslinking accelerator is preferably 0.001% by mass or more, more preferably 0.01% by mass or more, and still more preferably 0.04% by mass or more, and is preferably 10% by mass or less, more preferably 5% by mass or less, and still more preferably 1% by mass or less, with respect to 100% by mass of the nonvolatile components in the resin composition.

The resin composition according to the present embodiment may further contain an inorganic filler. By containing the inorganic filler, it is possible to decrease a linear thermal expansion coefficient and a dielectric dissipation factor furthermore.

Illustrative examples of the inorganic filler may include silica, alumina, barium sulfate, talc, clay, mica powder, aluminum hydroxide, magnesium hydroxide, calcium carbonate, magnesium carbonate, magnesium oxide, boron nitride, aluminum borate, barium titanate, strontium titanate, calcium titanate, magnesium titanate, bismuth titanate, titanium dioxide, barium zirconate, and calcium zirconate. Among these, silica is preferable. Illustrative examples of the silica may include amorphous silica, fused silica, crystalline silica, synthetic silica, and hollow silica. As the silica, a spherical silica is preferable. The inorganic filler may be used singly or as a combination of two or more of them. Illustrative examples of the commercially available inorganic filler may include "UFP-30" (manufactured by Denka Co., Ltd.); "YC100C", "YA050C", "YA050C-MJE", "YA010C", "SC2500SQ", "SO-C4", "SO-C2", "SO-C1", and "SC-C2" (all being manufactured by Admatechs Co., Ltd.); and "Silfil NSS-3N", "Silfil NSS-4N", and "Silfil NSS-5N" (manufactured by Tokuyama Corp).

From the viewpoint of lowering the roughness of the surface of an insulating layer formed of a cured product thereby facilitating formation of a fine wiring, the average particle diameter of the inorganic filler is preferably 5 µm or less, more preferably 2 µm or less, and still more preferably 1 µm or less. The lower limit of the average particle diameter is not particularly restricted; the lower limit may be, for example, 0.01 µm or more, 0.02 µm or more, or 0.03 µm or more. The average particle diameter of the inorganic filler can be measured with a laser diffraction scattering method based on the Mie scattering theory. Specifically, the particle diameter distribution of the inorganic filler is prepared on a volume basis by using a laser diffraction scattering type particle diameter distribution measurement instrument, in which the median diameter thereof can be measured as the average particle diameter. The measurement sample can be prepared by weighing 100 mg of the inorganic filler and 10 g of methyl ethyl ketone in a vial followed by dispersing it by means of an ultrasound for 10 minutes. Using the measurement sample and a laser diffraction particle diameter distribution measurement instrument with blue and red light source wavelengths, the volume-based particle diameter distribution of the inorganic filler is measured by the flow cell method; then, the average particle diameter may be calculated as the median diameter from the particle diameter distribution thus obtained. Illustrative examples of the laser diffraction particle diameter distribution measurement instrument may include "LA-960" manufactured by HORIBA, Ltd.

The inorganic filler is preferably those whose surfaces has been subjected to a surface treatment with a surface treatment agent such as an aminosilane type coupling agent, a ureidosilane type coupling agent, an epoxysilane type coupling agent, a mercaptosilane type coupling agent, a vinyl silane type coupling agent, a styryl silane type coupling agent, an acrylate silane type coupling agent, an isocyanate silane type coupling agent, a sulfide silane type coupling agent, an organosilazane compound, and a titanate type coupling agent in order to enhance the moisture resistance and dispersibility thereof.

When the resin composition according to the present embodiment contains the inorganic filler, the amount of the inorganic filler in the resin composition may be determined in accordance with the properties required for the resin composition. The amount of the inorganic filler in the resin composition is, for example, 5% by mass or more, or 10% by mass or more, preferably 30% by mass or more, more preferably 40% by mass or more, and still more preferably 50% by mass or more, with respect to 100% by mass of the nonvolatile components in the resin composition. The upper limit of the amount of the inorganic filler is not particularly restricted, but the upper limit may be, for example, 90% by mass or less, or 85% by mass or less.

The resin composition according to the present embodiment may further contain a thermoplastic resin. When the resin composition contains a thermoplastic resin, the mechanical strength of the cured product can be enhanced, and moreover, the film forming ability can be enhanced when used in the form of a resin sheet.

Illustrative examples of the thermoplastic resin may include a phenoxy resin, a polyvinyl acetal resin, a polyimide resin, a polyamide imide resin, a polyether imide resin, a polysulfone resin, a polyether sulfone resin, a polyphenylene ether resin, a polycarbonate resin, a polyether ether ketone resin, and a polyester resin. Among these, a phenoxy resin and a polyvinyl acetal resin are preferable. The thermoplastic resin may be used singly or as a combination of two or more of them. The weight-average molecular weight of the thermoplastic resin is preferably in the range of 8000 to 200000, and more preferably in the range of 12000 to 100000.

The amount of the thermoplastic resin is not particularly restricted, but the amount is preferably 0.001% by mass or more, more preferably 0.01% by mass or more, still more preferably 0.1% by mass or more, and especially preferably 0.5% by mass or more, and is preferably 10% by mass or less, and more preferably 5% by mass or less, with respect to 100% by mass of the nonvolatile components in the resin composition.

The resin composition according to the present embodiment may further contain an optional additive. Illustrative examples of the additive may include: organic fillers such as a rubber particle; radical polymerization initiators such as a peroxide type radical polymerization initiator and an azo type radical polymerization initiator; optional resin crosslinking agents other than the active ester resin, such as a phenol type crosslinking agent, a benzoxazine type crosslinking agent, an acid anhydride type crosslinking agent, and a cyanate ester type crosslinking agent; organic metal compounds such as an organic copper compound, an organic zinc compound, and an organic cobalt compound; coloring agents such as a phthalocyanine blue, a phthalocyanine green, an iodine green, a diazo yellow, a crystal violet, titanium dioxide, and carbon black; polymerization inhibitors such as hydroquinone, catechol, pyrogallol, and phenothiazine; leveling agents such as a silicone type leveling agent and an acrylic polymer type leveling agent; thickeners such as bentone and montmorillonite; antifoaming agents such as a silicone type antifoaming agent, an acrylic type antifoaming agent, a fluorine type antifoaming agent, and a vinyl resin type antifoaming agent; ultraviolet absorbers such as a benzotriazole type ultraviolet absorber; adhesion enhancers such as a urea silane; adhesion assisting agents such as a triazole type adhesion assisting agent, a tetrazole type adhesion assisting agent, and a triazine type adhesion assisting agent; antioxidants such as a hindered phenol type antioxidant; fluorescent brighteners such as a stilbene derivative; surfactants such as a fluorine type surfactant and a silicone type surfactant; flame retardants such as phosphorous type flame retardants (for example, a phosphate ester compound, a phosphazene compound, a phosphinate compound, and red phosphorus), nitrogen type flame retardants (for example, melamine sulfate), halogen type flame retardants, and inorganic type flame retardants (for example, antimony trioxide); dispersants such as a phosphate ester type dispersant, a polyoxyalkylene type dispersant, an acetylene type dispersant, a silicone type dispersant, an anionic dispersant, and a cationic dispersant; and stabilizers such as a borate type stabilizer, a titanate type stabilizer, an aluminate type stabilizer, a zirconate type stabilizer, an isocyanate type stabilizer, a carboxylate type stabilizer, and a carboxylic anhydride type stabilizer. The amount of such additives may be determined in accordance with the properties required for the resin composition.

The resin composition according to the present embodiment may further contain an organic solvent as a volatile component. Illustrative examples of the organic solvent may include: ketone type solvents such as acetone, methyl ethyl ketone, methyl isobutyl ketone, and cyclohexanone; ester type solvents such as methyl acetate, ethyl acetate, butyl acetate, isobutyl acetate, isoamyl acetate, methyl propionate, ethyl propionate, and γ-butyrolactone; ether type solvents such as tetrahydropyran, tetrahydrofuran, 1,4-dioxane, diethyl ether, diisopropyl ether, dibutyl ether, and diphenyl ether; alcohol type solvents such as methanol, ethanol, propanol, butanol, and ethyleneglycol; ether ester type solvents such as 2-ethoxyethyl acetate, propyleneglycol monomethyl ether acetate, diethyleneglycol monoethyl ether acetate, ethyldiglycol acetate, γ-butyrolactone, and methyl methoxypropionate; ester alcohol type solvents such as methyl lactate, ethyl lactate, and methyl 2-hydroxyisobutyrate; ether alcohol type solvents such as 2-methoxypropanol, 2-methoxyethanol, 2-ethoxyethanol, propyleneglycol monomethyl ether, and diethyleneglycol monobutyl ether (butyl carbitol); amide type solvents such as N,N-dimethylformamide, N,N-dimethylacetamide, and N-methyl-2-pyrrolidone; sulfoxide type solvents such as dimethyl sulfoxide; nitrile type solvents such as acetonitrile and propionitrile; aliphatic hydrocarbon type solvents such as hexane, cyclopentane, cyclohexane, and methylcyclohexane; and aromatic hydrocarbon type solvents such as benzene, toluene, xylene, ethylbenzene, and trimethylbenzene. The organic solvent may be used singly or in a combination of two or more of them.

When the resin composition according to the present embodiment contains an organic solvent, the amount of the organic solvent in the resin composition may be determined in accordance with the properties required for the resin composition. The amount of the organic solvent in the resin composition may be, for example, 60% by mass or less, 40% by mass or less, 30% by mass or less, 20% by mass or less, 15% by mass or less, and 10% by mass or less, with respect to 100% by mass of all the components in the resin composition.

The resin composition according to the present embodiment can be produced by mixing necessary components among those described above as appropriate, and also as needed kneading or mixing by means of a kneader such as a three-rolls mixer, a ball mill, a bead mill, or a sand mill, or by means of an agitator such as a super mixer or a planetary mixer.

By curing the resin composition according to the present embodiment, the cured product thereof can be obtained. Usually, volatile components such as an organic solvent contained in the resin composition may be volatilized by heat that is given during curing, but nonvolatile components such as the active ester resin, the crosslinkable resin, the crosslinking accelerator, the inorganic filler, the thermoplastic resin, and the optional additive are not volatilized by heat during curing. Therefore, the cured product may contain nonvolatile components of the resin composition or reaction products thereof.

The resin composition according to the present embodiment containing the active ester resin and the crosslinkable resin in combination can bring about the cured product that exhibits low dielectric properties in a high temperature environment. Therefore, when the above-mentioned cured product is used for the insulating layer of a printed wiring board or of a semiconductor chip package, it is possible to reduce a transmission loss in a high temperature environment.

In one embodiment, the cured product of the resin composition according to the present embodiment can exhibit a low dielectric dissipation factor (Df) in a high temperature environment of 90°C. For example, as it will be described later in the section of "Measurement of dielectric properties (high temperature)" in Examples, the dielectric dissipation factor (Df) of the cured product of the resin composition according to the present embodiment measured with the measurement frequency of 10 GHz at 90°C may be preferably 0.01 or less, 0.008 or less, 0.007 or less, 0.006 or less, 0.005 or less, 0.004 or less, or 0.003 or less.

The cured product of the resin composition according to the present embodiment can usually exhibit a low dielectric dissipation factor (Df) at normal temperature. For example, as it will be described later in the section of "Measurement of dielectric properties (room temperature)" in Examples, the dielectric dissipation factor (Df) of the cured product of the resin composition according to the present embodiment measured with the measurement frequency of 5.8 GHz at 23°C may be preferably 0.01 or less, 0.008 or less, 0.006 or less, 0.005 or less, 0.004 or less, or 0.003 or less.

The cured product of the resin composition according to the present embodiment can usually exhibit a low relative dielectric constant (Dk) in a high temperature environment of 90°C. For example, as it will be described later in the section of "Measurement of dielectric properties (high temperature)" in Examples, the relative dielectric constant (Dk) of the cured product of the resin composition according to the present embodiment measured with the measurement frequency of 10 GHz at 90°C may be preferably 3.3 or less, 3.2 or less, 3.1 or less, 3.0 or less, or 2.8 or less.

The cured product of the resin composition according to the present embodiment can usually exhibit a low relative dielectric constant (Dk) at normal temperature. For example, as it will be described later in the section of "Measurement of dielectric properties (room temperature)" in Examples, the relative dielectric constant (Dk) of the cured product of the resin composition according to the present embodiment measured with the measurement frequency of 5.8 GHz at 23°C may be preferably 3.3 or less, 3.2 or less, 3.1 or less, 3.0 or less, or 2.8 or less.

The cured product of the resin composition according to the present embodiment can usually exhibit an excellent smear removability. In general, in the case where an insulating layer is formed of a cured product of a resin composition, holes such as a via hole and a through hole may be formed in the insulating layer. When such holes are formed in the insulating layer, a smear may be formed in the holes as a resin residual matter. A property of easiness in removal of the smear is called "smear removability". For example, when the smear removability is evaluated by the method described in the section of "Evaluation of smear removability" in Examples to be described later, the cured product of the resin composition according to the present embodiment can reduce the maximum smear extending length from the wall surface at the bottom of the via hole (maximum smear length) to less than 5 µm. In general, a shorter maximum smear length indicates a better smear removability.

Usually, the cured product of the resin composition according to the present embodiment can have the property of being difficult to cause a haloing defect after formation of a via hole. In general, an insulating layer may be formed on an inner layer board by a cured product of a resin composition. When a via hole is formed in this insulating layer and a roughening treatment is carried out, separation may occur between the insulating layer and the inner layer board around the via hole, resulting in forming a gap. The term "haloing" means the separation between the insulating layer and the inner layer board as described above. Usually, the cured product of the resin composition according to the present embodiment can suppress the extent of the haloing described above. For example, the haloing ratio, as measured by the method to be described later in the section of "Evaluation of haloing" in Examples, may be made preferably 50% or less. The haloing ratio indicates the size of the gap formed by haloing based on the dimension of the bottom on the inner layer board side in the via hole, in which the smaller this haloing ratio Hb is, the more effectively the haloing can be suppressed.

The resin composition according to the present embodiment can be suitably used as the resin composition for forming an insulating layer of a printed wiring board (resin composition for forming an insulating layer of a printed wiring board), and can be used more preferably as the resin composition for forming an interlayer insulating layer of a printed wiring board (resin composition for forming an interlayer insulating layer of a printed wiring board). The resin composition according to the present embodiment may also be suitably used when the printed wiring board is a component-embedded circuit board. The resin composition according to the present embodiment can also be suitably used as the resin composition for sealing a semiconductor chip (resin composition for sealing a semiconductor chip), and as the resin composition for forming a redistribution forming layer as the insulating layer for forming a redistribution layer (resin composition for a redistribution forming layer). The resin composition according to the present embodiment can be used in a wide range of applications where a resin composition is required, including a sheet-shaped laminate material such as a resin sheet and a prepreg, a solder resist, a underfill material, a die bonding material, a hole-filling resin, and a component-embedding resin.

### <Sheet-shaped laminate materials (resin sheet and prepreg)>

The resin composition according to the present embodiment may be used as it is, but the resin composition may be used in the form of a sheet-shaped laminate material containing this resin composition.

As for the sheet-shaped laminate material, the resin sheet and prepreg described below are preferable.

In one embodiment, the resin sheet comprises a support and a layer (hereinafter this layer is simply referred to as "resin composition layer") of the resin composition formed on the support. The resin composition layer contains the resin composition described above, and contains preferably only the resin composition described above.

The optimal thickness of the resin composition layer varies depending on the use thereof; thus, this may be determined as appropriate in accordance with the use thereof. From the viewpoint of thinning of a printed wiring board and of a semiconductor chip package, for example, the thickness of the resin composition layer is preferably 200 µm or less, more preferably 150 µm or less, 120 µm or less, 100 µm or less, 80 µm or less, 60 µm or less, or 50 µm or less. The lower limit of the thickness of the resin composition layer is not particularly restricted; usually, the lower limit may be 1 µm or more, or 5 µm or more.

Illustrative examples of the support may include a thermoplastic resin film, metal foil, and a releasing paper; a thermoplastic resin film and metal foil are preferable. Therefore, in one preferable embodiment, the support is a thermoplastic resin film or metal foil.

When the thermoplastic resin film is used as the support, illustrative examples of the thermoplastic resin may include: polyesters such as polyethylene terephthalate ("PET") and polyethylene naphthalate ("PEN"); polycarbonate ("PC"); acrylic polymers such as polymethyl methacrylate ("PMMA"); a cyclic polyolefin; triacetyl cellulose ("TAC"); polyether sulfide ("PES"); polyether ketone; and polyimide. Among these, polyethylene terephthalate and polyethylene naphthalate are preferable; an inexpensive polyethylene terephthalate is especially preferable.

When metal foil is used as the support, illustrative examples of the metal foil may include copper foil and aluminum foil; copper foil is preferable. As for the copper foil, a foil formed of a copper single metal may be used, and a foil formed of an alloy of copper with other metal (for example, tin, chromium, silver, magnesium, nickel, zirconium, silicon, and titanium) may be used.

The support may have been subjected to a surface treatment such as a mat treatment, a corona treatment, or an antistatic treatment, on the surface to be bonded with the resin composition layer. As for the support, a releasing layer-bonded support having a releasing layer on the surface to be bonded to the resin composition layer may also be used. The releasing agent to be used in the releasing layer of the releasing layer-bonded support may be one or more releasing agents selected from the group consisting of, for example, an alkyd resin, a polyolefin resin, a urethane resin, and a silicone resin. As for the releasing layer-bonded support, a commercially available product thereof may be used. Illustrative examples thereof may include PET films having a releasing layer mainly composed of an alkyd resin type releasing agent, such as "SK-1", "AL-5", and "AL-7", all being manufactured by Lintech Corp.; "Lumirror T60" manufactured by Toray Industries, Inc.; "PUREX" manufactured by Teijin Limited; and "UNIPEEL" manufactured by Unitika, Ltd.

There is no particular restriction in the thickness of the support; but the range of 5 µm to 75 µm is preferable, and the range of 10 µm to 60 µm is more preferable. When the release layer-bonded support is used, it is preferable that the thickness of the entire release layer-bonded support is within the range described above.

In the case where the metal foil is used as the support, a metal foil having a supporting substrate attached, which is thin metal foil that is laminated with a removable supporting substrate, may be used. In one embodiment, the metal foil having the supporting substrate attached contains a supporting substrate, a release layer formed on the supporting substrate, and metal foil formed on the release layer. When the metal foil having the supporting substrate attached is used as the support, the resin composition layer is formed on the metal foil.

In the metal foil having the supporting substrate attached, the material of the supporting substrate is not particularly restricted; illustrative examples thereof may include copper foil, aluminum foil, stainless steel foil, titanium foil, and copper alloy foil. When the copper foil is used as the supporting substrate, this may be electrolytic copper foil or rolled copper foil. The release layer is not particularly restricted as long as the metal foil can be removed from the supporting substrate; illustrative examples thereof may include an alloy layer of an element selected from the group consisting of Cr, Ni, Co, Fe, Mo, Ti, W, and P; and an organic film.

In the metal foil having the supporting substrate attached, for example, copper foil and copper alloy foil are preferable as the material of the metal foil.

In the metal foil having the supporting substrate attached, there is no particular restriction in the thickness of the supporting substrate, in which the range of 10 µm to 150 µm is preferable, and the range of 10 µm to 100 µm is more preferable. The thickness of the metal foil may be , for example, in the range of 0.1 µm to 10 µm.

In one embodiment, the resin sheet may further include an optional layer as needed. Illustrative examples of the optional layer may include a protective film, which is formed on the surface (namely, on the surface opposite to the support) of the resin composition layer not being in contact with the support. There is no particular restriction in the thickness of the protective film; the thickness is, for example, 1 µm to 40 µm. When the protective film is laminated, the surface of the resin composition layer can be prevented from attachment of dirt and from formation of a scar.

The resin sheet can be produced, for example, by applying a liquid resin composition as it is or a resin varnish that is prepared by dissolving the resin composition in an organic solvent, by using a die coater or the like onto the support, which is then followed by drying it to form the resin composition layer.

Examples of the organic solvent may include the same organic solvents as those described as the component of the resin composition. The organic solvent may be used singly or in a combination of two or more of them.

Drying may be performed, for example, by a drying method such as heating or blowing a hot air. There is no particular restriction in the drying condition; the drying is performed in such a way as to bring the amount of the organic solvent in the resin composition layer usually to 10% by mass or less, and preferably to 5% by mass or less. For example, in the case where the resin composition or the resin varnish containing 30% by mass to 60% by mass of the organic solvent is used, drying can be carried out at 50°C to 150°C for the period of 3 minutes to 10 minutes to form the resin composition layer, although these condition vary depending on the boiling point of the organic solvent in the resin composition or the resin varnish.

The resin sheet can be rolled up so as to be stored. When the resin sheet includes the protective film, the resin sheet can be used by removing the protective film.

In one embodiment, a prepreg is formed by impregnating a sheet-shaped fiber substrate with the resin composition.

The sheet-shaped fiber substrate used for the prepreg is not particularly restricted; the material that is commonly used as the substrate for the prepreg, such as a glass cloth, an aramid non-woven cloth, or a liquid crystal polymer non-woven cloth, may be used. From the viewpoint of making a printed wiring board and a semiconductor chip package thinner, the thickness of the sheet-shaped fiber substrate is preferably 50 µm or less, more preferably 40 µm or less, still more preferably 30 µm or less, and especially preferably 20 µm or less. The lower limit of the thickness of the sheet-shaped fiber substrate is not particularly restricted. Usually, this is 10 µm or more.

The prepreg can be produced by a known method such as a hot-melt method and a solvent method.

The thickness of the prepreg may be in the same range as the resin composition layer in the resin sheet described before.

The sheet-shaped laminate material can be preferably used for forming an insulating layer of a printed wiring board (for an insulating layer of a printed wiring board), and can be more preferably used for forming an interlayer insulating layer of a printed wiring board (for an interlayer insulating layer of a printed wiring board). The sheet-shaped laminate material can also be preferably used for sealing a semiconductor chip (for sealing of a semiconductor chip) and for a redistribution forming layer as the insulating layer to form a redistribution layer.

### <Printed wiring board>

The printed wiring board according to one embodiment of the present invention includes an insulating layer formed of the cured product of the resin composition described above. This insulating layer contains the cured product of the resin composition described above, and contains preferably only the cured product of the resin composition described above.

The printed wiring board can be produced, for example, by a method including
(i) a step of forming a resin composition layer on an inner layer board, and
(ii) a step of curing (for example, thermal curing) the resin composition layer to form an insulating layer.

In the step (i), the resin composition layer may be formed by applying the resin composition onto the inner layer board, but it is preferable to laminate a resin sheet on the inner layer board such that the resin composition layer of the resin sheet would be bonded to the inner layer board.

Illustrative examples of the "inner layer board" used at the step (i), which is a member to form a substrate for a printed wiring board, may include a glass epoxy substrate, a metal substrate, a polyester substrate, a polyimide substrate, a BT resin substrate, and a thermosetting type polyphenylene ether substrate. The board may include a conductor layer on one or both sides thereof, in which this conductor layer may be patterned. The inner layer board having a conductor layer (circuit) formed on one or both sides of the board may be referred to as an "inner layer circuit board". An intermediate product, which is produced in production of a printed wiring board and to which an insulating layer and/or a conductor layer is to be formed, is included in the "inner layer board" in the present specification. In the case where the printed wiring board is a component-embedded circuit board, the inner layer board having the embedded component may be used.

Lamination of the inner layer board with the resin sheet can be performed, for example, by a heat-compression bonding of the resin sheet to the inner layer board by pressing from the support side. Illustrative examples of the member (hereinafter, this may be referred to as "heat-compression bonding member") used for the heat-compression bonding of the resin sheet to the inner layer board may include a metal plate (such as a SUS mirror plate) and a metal roll (such as a SUS roll) which are heated. Here, the heat-compression bonding member may be pressed in direct contact with the resin sheet, but the pressing may be made via an elastic material such as a heat-resistant rubber in such a way that the resin sheet can well follow the surface irregularity of the inner layer board.

Lamination of the resin sheet with the inner layer board may be performed by a vacuum lamination method. In the vacuum lamination method, the heat-compression bonding temperature is preferably 60°C to 160°C, and more preferably 80°C to 140°C. The heat-compression bonding pressure is preferably 0.098 MPa to 1.77 MPa, and more preferably 0.29 MPa to 1.47 MPa. The heat-compression bonding time is preferably 20 seconds to 400 seconds, and more preferably 30 seconds to 300 seconds. The lamination may be performed preferably under a reduced pressure of 26.7 hPa or lower.

The lamination can be performed with a commercially available vacuum laminator. Illustrative examples of the commercially available vacuum laminator may include a vacuum pressing laminator manufactured by Meiki Co., Ltd., as well as a vacuum applicator and a batch type vacuum pressing laminator manufactured by Nikko Materials Co., Ltd.

After the lamination, the resin sheet thereby laminated may be subjected to, for example, a flattening treatment by pressing the heat-compression bonding member from the support side under a normal pressure (under an atmospheric pressure). The pressing conditions of the flattening process may be the same as the heat-compression bonding conditions in the aforementioned lamination. The flattening treatment can be performed by a commercially available laminator. The lamination and the flattening treatments may be carried out continuously by using a commercially available vacuum laminator.

The support may be removed between the step (i) and the step (ii), or may be removed after the step (ii). In the case where the metal foil is used as the support, a conductor layer may be formed using this metal foil without removing the support. In the case where the metal foil having the supporting substrate attached is used as the support, the supporting substrate (and a release layer) may be removed. Then, the conductor layer can be formed by using metal foil.

In the step (ii), the resin composition layer is cured (for example, thermally cured) to form the insulating layer comprising the cured product of the resin composition. The curing conditions of the resin composition layer are not particularly restricted; the conditions usually employed in forming the insulating layer of a printed wiring board may be used.

The thermal curing conditions of the resin composition layer vary depending on the type of resin composition. In one embodiment, for example, the curing temperature is preferably 120°C to 250°C, more preferably 150°C to 240°C, and still more preferably 180°C to 230°C. The curing time may be preferably 5 minutes to 240 minutes, more preferably 10 minutes to 150 minutes, and still more preferably 15 minutes to 120 minutes.

Before thermally curing the resin composition layer, the resin composition layer may be preliminarily heated at a temperature lower than the curing temperature. For example, prior to thermally curing the resin composition layer, the resin composition layer may be preliminarily heated at a temperature of usually 50°C to 120°C, preferably 60°C to 115°C, and more preferably 70°C to 110°C, usually for 5 minutes or longer, preferably for 5 minutes to 150 minutes, more preferably for 15 minutes to 120 minutes, and still more preferably for 15 minutes to 100 minutes.

In producing a printed wiring board, (iii) a step of forming a hole in the insulating layer, (iv) a step of subjecting the insulating layer to a roughening treatment, and (v) a step forming a conductor layer may be further performed. The steps (iii) through (v) may be performed using any method known to a person ordinarily skilled in the art for production of a printed wiring board. In the case where the support is removed after the step (ii), the removal of the support may be performed between the step (ii) and the step (iii), between the step (iii) and the step (iv), or between the step (iv) and the step (v). In addition, as needed, the formation of the insulating layer and the conductor layer at the step (i) through the step (v) may be repeated to form a multilayer wiring board.

In another embodiment, the printed wiring board may be produced using the prepreg described before. The production method thereof is basically the same as the method that is used when the resin sheet is used.

The step (iii) is the step of forming a hole thorough the insulating layer; with this, the holes such as a via hole and a through hole can be formed in the insulating layer. The step (iii) may be performed using, for example, a drill, a laser, and a plasma, depending on the composition of the resin composition used to form the insulating layer. The dimension and shape of the hole may be determined as appropriate in accordance with the design of the printed wiring board.

The step (iv) is the step of subjecting the insulating layer to the roughening treatment. Usually, smear removal (desmearing) is also performed at this step (iv). The procedure and condition of the roughening treatment are not particularly restricted; thus, any known procedure and condition usually used to form the insulating layer of a printed wiring board may be used. For example, the roughening treatment of the insulating layer can be performed by carrying out a swelling process using a swelling liquid, a roughening process using an oxidant, and a neutralizing process using a neutralizing solution in this order.

The swelling liquid to be used for the roughening treatment is not particularly restricted. Illustrative examples thereof may include an alkali solution and a surfactant solution. Among these, an alkali solution is preferable. As for the alkali solution, a sodium hydroxide solution and a potassium hydroxide solution are more preferable. Illustrative examples of the swelling liquid that is commercially available may include "Swelling Dip Securiganth P" and "Swelling Dip Securiganth SBU", which are both manufactured by Atotech Japan Co., Ltd. The swelling process using the swelling liquid is not particularly restricted; this process may be performed, for example, by immersing the insulating layer into the swelling liquid at the temperature of 30°C to 90°C for the period of 1 minute to 20 minutes. From the viewpoint of suppressing the swelling of the resin in the insulating layer to a suitable level, it is preferable that the insulating layer is immersed into the swelling liquid at the temperature of 40°C to 80°C for the period of 5 minutes to 15 minutes.

The oxidant to be used for the roughening treatment is not particularly restricted. An example thereof may be an alkaline permanganate solution having potassium permanganate or sodium permanganate dissolved into a sodium hydroxide aqueous solution. The roughening process using the oxidant such as the alkaline permanganate solution is performed preferably by immersing the insulating layer into the oxidant solution heated at 60°C to 100°C for the period of 10 minutes to 30 minutes. The concentration of the permanganate salt in the alkaline permanganate solution is preferably 5% by mass to 10% by mass. Illustrative examples of the oxidant that is commercially available may include alkaline permanganate solutions such as "Concentrate Compact CP" and "Dosing Solution Securiganth P", both of which are manufactured by Atotech Japan, Co., Ltd.

The neutralizing solution to be used for the roughening treatment is preferably an aqueous acidic solution. A commercially available neutralizing solution is, for example, "Reduction Solution Securigance P" manufactured by Atotech Japan Co., Ltd. The process with the neutralizing solution can be performed by immersing the treated surface, which has been subjected to the roughening process using the oxidant, into the neutralizing solution at the temperature of 30°C to 80°C for the period of 5 minutes to 30 minutes. From the viewpoint of workability and so forth, it is preferable to use the method in which the object that has been subjected to the roughening process using the oxidant is immersed into the neutralizing solution at the temperature of 40°C to 70°C for the period of 5 minutes to 20 minutes.

The step (v) is the step of forming the conductor layer. The conductor layer is formed on the insulating layer. The conductive material used in the conductor layer is not particularly restricted. In a preferable embodiment, the conductor layer contains one or more metals selected from the group consisting of gold, platinum, palladium, silver, copper, aluminum, cobalt, chromium, zinc, nickel, titanium, tungsten, iron, tin, and indium. The conductor layer may be a single metal layer or an alloy layer. The alloy layer is, for example, a layer formed of an alloy (for example, a nickel-chromium alloy, a copper-nickel alloy, and a copper-titanium alloy) of two or more metals selected from the above-mentioned group. Among these, from the viewpoints of versatility in formation of the conductor layer, cost, easiness in patterning, and the like, a single metal layer of chromium, nickel, titanium, aluminum, zinc, gold, palladium, silver, or copper, or an alloy layer of a nickel-chromium alloy, a copper-nickel alloy, or a copper-titanium alloy is preferable. A single metal layer of chromium, nickel, titanium, aluminum, zinc, gold, palladium, silver, or copper, or an alloy layer of a nickel-chromium alloy is more preferable. A single metal layer of copper is still more preferable.

The conductor layer may have a single layer structure, or may have a multilayer structure including two or more single metal layers or alloy layers formed of different metals or alloys. In the case where the conductor layer has a multilayer structure, the layer in contact with the insulating layer is preferably a single metal layer of chromium, zinc, or titanium, or an alloy layer of a nickel-chromium alloy.

The thickness of the conductor layer is generally 3 µm to 35 µm, and preferably 5 µm to 30 µm, although the range is different depending on the design of an intended printed wiring board.

In one embodiment, the conductor layer may be formed by plating. For example, the conductor layer having an intended wiring pattern can be formed by plating on the surface of the insulating layer using a conventionally known technology such as a semi-additive method and a full-additive method. From the viewpoint of simplicity in the production, it is preferable to form by a semi-additive method. Hereinafter, the example in which the conductor layer is formed by a semi-additive method will be described.

First, a plating seed layer is formed on the surface of the insulating layer by an electroless plating. Next, a mask pattern is formed on the formed plating seed layer such that a part of the plating seed layer corresponding to an intended wiring pattern will be exposed. After forming a metal layer on the exposed plating seed layer by an electrolytic plating, the mask pattern is removed. Then, the conductor layer having an intended wiring pattern can be formed by removing an unnecessary plating seed layer by etching or the like.

In another embodiment, the conductor layer may be formed using metal foil. In the case where the conductor layer is formed by using metal foil, it is preferable that the step (v) is performed between the step (i) and the step (ii). For example, after the step (i), the support is removed, and then metal foil is laminated on the surface of the exposed resin composition layer. Lamination of the resin composition layer and the metal foil may be performed by a vacuum lamination method. The conditions for this lamination may be the same as those described for the step (i). Next, the step (ii) is performed to form the insulating layer. Then, by using the metal foil on the insulating layer, the conductor layer having an intended wiring pattern can be formed by using a conventional known technology such as a subtractive method and a modified semi-additive method.

The metal foil can be produced by a known method such as an electrolysis method and a rolling method. Illustrative examples of the commercially available metal foil may include HLP foil and JXUT-III foil manufactured by JX Metals Corp., and 3EC-III foil and TP-III foil manufactured by Mitsui Mining & Smelting Co., Ltd.

Alternatively, in the case where metal foil or the metal foil having the supporting substrate attached is used as the support for the resin sheet, the conductor layer may be formed by using such metal foil, as described before.

### <Semiconductor chip package>

The semiconductor chip package may include a sealing layer formed of the cured product of the resin composition described before. The sealing layer contains the cured product of the resin composition described before, and contains preferably only the cured product of the resin composition described before. The semiconductor chip package may include the insulating layer (redistribution forming layer), which is formed of the cured product of the resin composition described above, for forming a redistribution layer .

The semiconductor chip package can be produced, for example, by the method including the steps (1) to (6) described below using the resin composition or the resin sheet described before. To form the sealing layer at the step (3) or to form the redistribution forming layer at the step (5), the resin composition and the resin sheet described before may be used. Hereinafter, one example of forming the sealing layer and the redistribution forming layer by using the resin composition and the resin sheet will be described. The technology for forming the sealing layer and the redistribution forming layer of the semiconductor chip package are known, so that a person ordinarily skilled in the art can produce the semiconductor package with a known technology by using the resin composition and the resin sheet.
(1) A step of laminating a temporary fixing film to a substrate.
(2) A step of temporarily fixing a semiconductor chip on the temporary fixing film.
(3) A step of forming a sealing layer on the semiconductor chip.
(4) A step of removing the substrate and the temporary fixing film from the semiconductor chip.
(5) A step of forming a redistribution forming layer as an insulating layer on the surface of the semiconductor chip from which the substrate and the temporary fixing film have been removed.
(6) A step of forming a redistribution layer as a conductor layer on the redistribution forming layer.

### -Step (1)-

The material to be used for the substrate is not particularly restricted. Illustrative examples of the substrate may include a silicon wafer; a glass wafer; a glass substrate; metal substrates such as copper, titanium, stainless steel, and steel plate cold commercial (SPCC); a substrate formed of a glass fiber that is impregnated with an epoxy resin or the like followed by thermal curing (for example, FR-4 substrate); and a substrate formed of a bismaleimidotriazine resin (BT resin).

The material for the temporary fixing film is not particularly restricted as long as this is capable of removing from the semiconductor chip at the step (4) and is capable of temporarily fixing the semiconductor chip. Commercially available products may be used for the temporary fixing film. Examples of the commercially available product thereof may include RIVALPHA manufactured by Nitto Denko Corp.

### -Step (2)-

Temporary fixing of the semiconductor chip can be performed using a known device such as a flip chip bonder and a die bonder. The layout and the number of the semiconductor chip in the arrangement thereof may be determined as appropriate in accordance with the shape and size of the temporary fixing film, and with the number of the semiconductor packages to be produced; for example, the semiconductor chips may be temporarily fixed by aligning them in a matrix of multiple rows and multiple columns.

### -Step (3)-

The resin composition layer is formed on the semiconductor chip and then cured (for example, thermally cured) to form the sealing layer. The resin composition layer can be formed, for example, by the method in which the resin composition layer of the resin sheet is laminated on the semiconductor chip or the method in which the resin composition is applied onto the semiconductor chip.

For example, lamination of the semiconductor chip with the resin sheet can be performed by removing the protective film from the resin sheet followed by heat-compression bonding the resin sheet from the support side onto the semiconductor chip. Illustrative examples of the heat-compression bonding member used for the heat-compression bonding of the resin sheet to the semiconductor chip may include a metal plate (such as a SUS mirror plate) and a metal roll (SUS roll) that are heated. Here, the heat-compression bonding member is not pressed in direct contact with the resin sheet; it is preferable that the pressing is made via an elastic material such as a heat-resistant rubber in such a way that the resin sheet can well follow the irregularity of the surface of the semiconductor chip. The lamination of the semiconductor chip with the resin sheet may be performed by a vacuum lamination method, in which the lamination conditions may be the same as those described with regard to the production method of the printed wiring board, and the same is true with regard to the preferable ranges.

After the lamination, the resin composition is thermally cured to form the sealing layer. The conditions for the thermal curing may be the same as those described with regard to the thermal curing in relation to the production method of the printed wiring board.

The support of the resin sheet may be removed after the resin sheet is laminated to the semiconductor chip and thermally cured. The support may be removed before the resin sheet is laminated to the semiconductor chip.

In the case where the resin composition is applied to form the sealing layer, the application conditions may be the same as the application conditions for forming the resin composition layer described with regard to the resin sheet, and the same is true with regard to the preferable ranges.

### -Step (4)-

The method of removing the substrate and the temporary fixing film may be changed as appropriate in accordance with the material of the temporary fixing film. Illustrative examples of the method may include the method in which the temporary fixing film is removed by heating and foaming (or expanding), and the method in which the temporary fixing film is removed by irradiating an ultraviolet light from the side of the substrate to lower the adhesive strength thereof.

In the method of removing the temporary fixing film by heating and foaming (or expanding), the heating conditions are usually the temperature of 100°C to 250°C and the period of 1 second to 90 seconds, or 5 minutes to 15 minutes. In the method of removing by irradiating an ultraviolet light from the side of the substrate to lower the adhesive strength of the temporary fixing film, the irradiation amount of the ultraviolet light is usually 10 mJ/cm² to 1000 mJ/cm².

### -Step (5)-

The material used to form the redistribution forming layer (insulating layer) is not particularly restricted as long as the redistribution forming layer (insulating layer) has an insulating property. From the viewpoint of ease of producing the semiconductor chip package, an ultraviolet-curable resin and a thermosetting resin are preferable. The redistribution forming layer may be formed by using the resin composition or the resin sheet described before.

After forming the redistribution forming layer, a via hole may be formed in the redistribution forming layer for interlayer connection between the semiconductor chip and the conductor layer to be described later. The via hole may be formed by using a known method, depending on the material of the redistribution forming layer.

### -Step (6)-

Formation of the conductor layer on the redistribution forming layer may be performed in the same way as the step (v) described with regard to the production method of the printed wiring board. The steps (5) and (6) may be repeated so as to alternately stack (build up) the conductor layer (redistribution layer) and the redistribution forming layer (insulating layer).

In producing the semiconductor chip package, (7) a step of forming a solder resist layer on the conductor layer (redistribution layer), (8) a step of forming a bump, and (9) a step of dicing and individualizing a plurality of the semiconductor chip packages into individual semiconductor chip packages may be carried out. Each step may be performed in accordance with various methods known to a person ordinarily skilled in the art for production of a semiconductor chip package.

When the sealing layer or the redistribution forming layer is formed using the resin composition or the resin sheet described before, regardless of whether the semiconductor package is a fan-in type package or a fan-out type package, it is possible to realize a semiconductor chip package with an extremely low transmission loss. In addition, with this semiconductor chip package, a low transmission loss can be realized especially in a high temperature environment. In one embodiment, the semiconductor chip package is a fan-out type package. The resin composition and the resin sheet according to the embodiment described above are applicable to both a fan-out type panel-level package (FO-PLP) and a fan-out wafer-level package (FO-WLP). In one embodiment, the semiconductor package is a fan-out panel-level package (FOPLP). In another embodiment, the semiconductor package is a fan-out wafer-level package (FOWLP).

### <Semiconductor device>

The semiconductor device according to one embodiment of the present invention includes a layer that contains the cured product of the resin composition according to the embodiment described before. This semiconductor device usually includes the printed wiring board or the semiconductor chip package described above. Examples of the semiconductor device may include various semiconductor devices for electric products (for example, a computer, a mobile phone, a digital camera, and a television) and for vehicles (for example, a motor bike, an automobile, a train, a marine ship, and an airplane).

### <Examples>

Hereinafter, the present invention will be described more specifically by means of Examples. The present invention is not limited to these Examples. In the description below, "part" and "%" that describe quantity mean "part by mass" and "% by mass", respectively, unless otherwise specifically mentioned. When the temperature is not specified in particular, the temperature condition of room temperature (23°C) was used. When the pressure is not specified in particular, the pressure condition of an atmospheric pressure (1 atm) was used.

### <Measurement conditions of mass spectrum>

In Examples and Comparative Examples to be described below, samples were diluted to 1 mg/mL with tetrahydrofuran (THF), and this was measured by a liquid chromatography-mass spectrometry (LC/MS) under the following conditions.
HPLC: ACQUITY UPLC (manufactured by Nihon Waters K.K.)
MS: SQ Detector2 (manufactured by Nihon Waters K.K.)
Column: ACQUITY UPLC BEH C8 1.7 µm, 2.1 mm x 50 mm (manufactured by Nihon Waters K.K.)
Mobile phase A: 2 mmol ammonium acetate solution
Mobile phase B: 2-propanol/THF (80:20)
Mixing time and mixing ratio (A%) of mobile phase: 0 min (50%) → 5 min (5%) → 12 min (5%) → 12.1 min (50%) → 14 min (50%)
Flow rate: 0.25 mL/min
Analysis time: 14 minutes
Column temperature: 40°C
Ion mode: ESI (Electron Spray Ionization) method, positive or negative
Ion polarity: positive detection mode or negative detection mode
Solvent removal gas flow rate: 700 L/hr, 250°C
Corn gas: 70L/hr
Ion source heater: 150°C

### <Measuring method of hydroxy equivalent>

In Examples and Comparative Examples described below, the hydroxy equivalent was determined by acetylating a hydroxy group in the sample with acetic anhydride-pyridine, followed by hydrolysis and back titration of the remaining acetic acid, in accordance with JIS-K0070.

### <Example 1: Synthesis of polyester resin (1a) containing the α-methylbenzyl group>

### (1-1) Synthesis of aromatic dihydroxy compound (1x) containing the α-methylbenzyl group

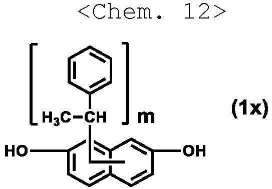

Into a four-necked round flask equipped with a stirrer, a thermometer, and a condenser, 224.0 g (1.4 moles) of 2,7-dihydroxynaphthalene (reagent), 291.2 g (2.8 moles) of styrene monomer (reagent), 5.2 g of paratoluenesulfonic acid monohydrate (reagent) as the acid catalyst, and 1300 g of toluene as the reaction solvent were added so as to obtain a composition ratio that would give the m value of 2.0 in the theoretical structure represented by the formula (1x); then, the temperature of the resulting mixture was raised to 100°C with taking care of the exothermic reaction. Then, the reaction was carried out at 100°C for 6 hours. After the temperature was then lowered to 60°C, 300 g of distilled water and an appropriate amount of a 48% sodium hydroxide aqueous solution for neutralization was added, which was followed by a static phase separation; then, the lower water phase containing the by-produced sodium chloride was discarded. The product was further purified by adding an equal volume of distilled water thereby washing it twice with water, and then heated for azeotropic dehydration. Then, after the resulting solution was microfiltrated to remove impurities, toluene was removed by distillation under a reduced pressure at a maximum temperature of 120°C to obtain 490 g of a solid product.

The hydroxy equivalent of this solid product was measured according to the measuring method described before to obtain a value of 187 g/eq. (theoretical value: 184 g/eq.).

The mass spectrum (negative ion mode) of the solid product was measured according to the measuring method described before. In the mass spectrum, the following spectral peaks were detected: m/z=263 which corresponds to the compound of m=1, m/z=367 which corresponds to the compound of m=2, and m/z=471 which corresponds to the compound of m=3. No peaks of the polynaphthylene ether structure, in which dihydroxy compounds were etherified with each other, were detected.

From these analytical data, it was confirmed that the obtained solid product had the intended molecular structure, i.e., the structure of the α-methylbenzyl-modified aromatic dihydroxy compound (1x) having the theoretical structure represented by the formula (1x).

### (1-2) Esterification reaction: synthesis of polyester resin (1a) containing the α-methylbenzyl group

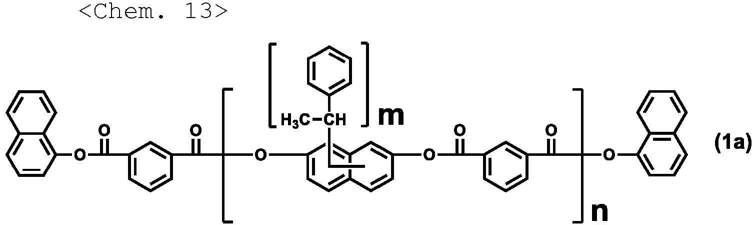

Into a four-necked round flask equipped with a stirrer, a thermometer, a dropping funnel, and a nitrogen gas inlet, 441.6 g (2.4 moles of hydroxy group) of the α-methylbenzyl-modified aromatic dihydroxy compound (1x) obtained at the step (1-1) above, 345.6 g (2.4 moles) of 1-naphthol (reagent), 487.2 g (2.4 moles) of isophthalic acid chloride (reagent), 1.3 g of tetra-n-butylammonium bromide (reagent), and 1100 g of toluene were added so as to obtain a composition ratio that would give the n value of 1.0 in the theoretical structure represented by the formula (1a) and the active ester equivalent of 229 g/eq.; then, while flowing a nitrogen gas, the resulting mixture was stirred to completely dissolve these compounds. At 30°C, 771.7 g (4.8 moles) of a 25% caustic soda aqueous solution was added dropwise over a period of 2 hours with raising the temperature finally to 60°C with taking care of the exothermic reaction. Then, after the stirring was further continued for 2 hours at 60°C, 300 g of distilled water was added, which was followed by a static phase separation; then, the lower water phase containing the by-produced sodium chloride was discarded. The product was further purified by adding an equal volume of distilled water thereby washing it twice with water, and then heated for azeotropic dehydration. Then, after the resulting solution was microfiltrated to remove impurities, toluene was removed by distillation under a reduced pressure at a maximum temperature of 200°C to obtain 950 g of a solid product.

The mass spectrum (positive ion mode) of the obtained solid product was measured according to the measuring method described before. In the mass spectrum, the following spectral peaks were detected: m/z=917 which corresponds to the compound of m=2/n=1, and m/z=1415 which corresponds to the compound of m=2/n=2. From these analytical data, it was confirmed that the obtained solid product had the intended molecular structure, i.e., the structure of the polyester resin (1a) containing the α-methylbenzyl group having the theoretical structure represented by the formula (1a).

### <Example 2: synthesis of polyester resin (2a) containing the α-methylbenzyl group>

### (2-1) Synthesis of aromatic dihydroxy compound (2x) containing the α-methylbenzyl group

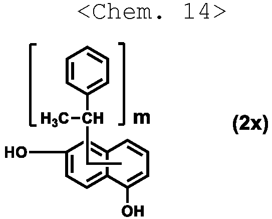

485 g of a solid product was obtained by the same way as the step (1-1) of Example 1, except that 2,7-dihydroxynaphthalene (reagent) was replaced with 224.0 g (1.4 moles) of 1,6-dihydroxynaphthalene (reagent).

The hydroxy equivalent of this solid product was measured according to the measuring method described before to obtain a value of 186 g/eq. (theoretical value: 184 g/eq.).

The mass spectrum (negative ion mode) of the solid product was measured according to the measuring method described before. In the mass spectrum, the following spectral peaks were detected: m/z=263 which corresponds to the compound of m=1, m/z=367 which corresponds to the compound of m=2, and m/z=471 which corresponds to the compound of m=3.

From these analytical data, it was confirmed that the obtained solid product had the intended molecular structure, i.e., the structure of the α-methylbenzyl-modified aromatic dihydroxy compound (2x) having the theoretical structure represented by the formula (2x).

### (2-2) Esterification reaction: synthesis of polyester resin (2a) containing the α-methylbenzyl group

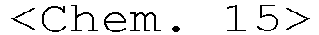

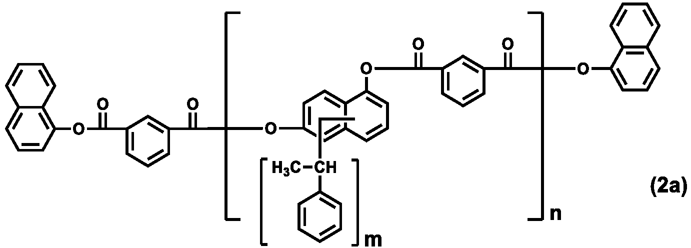

930 g of a solid product was obtained by the same way as the step (1-2) of Example 1, except that the α-methylbenzyl-modified aromatic dihydroxy compound (1x) was replaced with 441.6 g (2.4 moles of hydroxy group) of the α-methylbenzyl-modified aromatic dihydroxy compound (2x).

The mass spectrum (positive ion mode) of the obtained solid product was measured according to the measuring method described before. In the mass spectrum, the following spectral peaks were detected: m/z=917 which corresponds to the compound of m=2/n=1, and m/z=1415 which corresponds to the compound of m=2/n=2. No peaks of the polynaphthylene ether structure, in which dihydroxy compounds were etherified with each other, were detected. From these analytical data, it was confirmed that the obtained solid product had the intended molecular structure, i.e., the structure of the polyester resin (2a) containing the α-methylbenzyl group having the theoretical structure represented by the formula (2a).

### <Example 3: synthesis of polyester resin (3a) containing the α-methylbenzyl group>

### (3-1) Synthesis of aromatic dihydroxy compound (3x) containing the α-methylbenzyl group

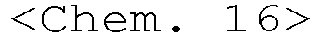

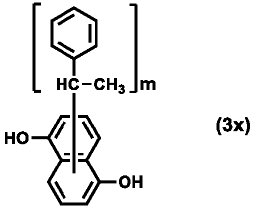

480 g of a solid product was obtained by the same way as the step (1-1) of Example 1, except that 2,7-dihydroxynaphthalene (reagent) was replaced with 224.0 g (1.4 moles) of 1,5-dihydroxynaphthalene (reagent).

The hydroxy equivalent of this solid product was measured according to the measuring method described before to obtain a value of 182 g/eq. (theoretical value: 184 g/eq.).

The mass spectrum (negative ion mode) of the solid product was measured according to the measuring method described before. In the mass spectrum, the following spectral peaks were detected: m/z=263 which corresponds to the compound of m=1, m/z=367 which corresponds to the compound of m=2, and m/z=471 which corresponds to the compound of m=3.

From these analytical data, it was confirmed that the obtained solid product had the intended molecular structure, i.e., the structure of the α-methylbenzyl-modified aromatic dihydroxy compound (3x) having the theoretical structure represented by the formula (3x).

### (3-2) Esterification reaction: synthesis of polyester resin (3a) containing the α-methylbenzyl group

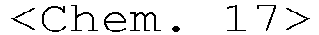

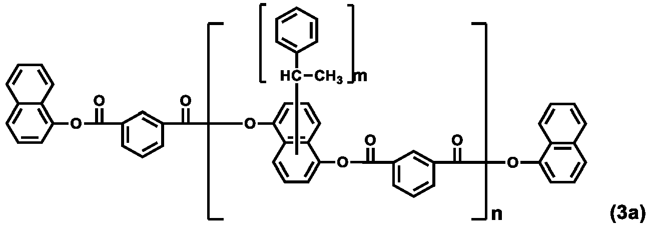

930 g of a solid product was obtained by the same way as the step (1-2) of Example 1, except that the α-methylbenzyl-modified aromatic dihydroxy compound (1x) was replaced with 441.6 g (2.4 moles of hydroxy group) of the α-methylbenzyl-modified aromatic dihydroxy compound (3x).

The mass spectrum (positive ion mode) of the obtained solid product was measured according to the measuring method described before. In the mass spectrum, the following spectral peaks were detected: m/z=917 which corresponds to the compound of m=2/n=1, and m/z=1415 which corresponds to the compound of m=2/n=2. No peaks of the polynaphthylene ether structure, in which dihydroxy compounds were etherified with each other, were detected. From these analytical data, it was confirmed that the obtained solid product had the intended molecular structure, i.e., the structure of the polyester resin (3a) containing the α-methylbenzyl group having the theoretical structure represented by the formula (3a).

### <Example 4: synthesis of polyester resin (4a) containing the α-methylbenzyl group>

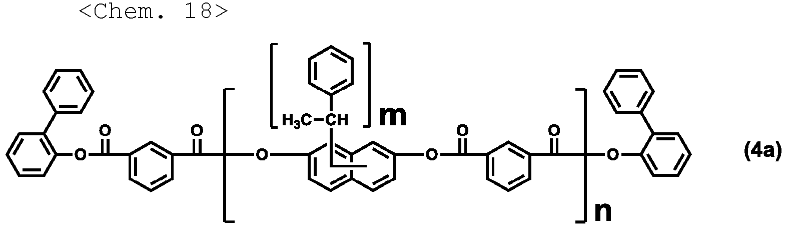

Into a four-necked round flask equipped with a stirrer, a thermometer, a dropping funnel, and a nitrogen gas inlet, 441.6 g (2.4 moles of hydroxy group) of the α-methylbenzyl-modified aromatic dihydroxy compound (1x) obtained by the same method as at the step (1-1) of Example 1, 136.0 g (0.8 moles) of 2-phenylphenol (reagent), 324.8 g (1.6 moles) of isophthalic acid chloride, 0.9 g of tetra-n-butylammonium bromide, and 1000 g of toluene were added so as to obtain a composition ratio that would give the n value of 3.0 in the theoretical structure represented by the formula (4a) and the active ester equivalent of 246 g/eq.; then, while flowing a nitrogen gas, the resulting mixture was stirred to completely dissolve these compounds. At 30°C, 512.0 g (3.2 moles) of a 25% caustic soda aqueous solution was added dropwise over a period of 2 hours with raising the temperature finally to 60°C with taking care of the exothermic reaction. Then, after the stirring was further continued for 2 hours at 60°C, 300 g of distilled water was added, which was followed by a static phase separation; then, the lower water phase containing the by-produced sodium chloride was discarded. The product was further purified by adding an equal volume of distilled water thereby washing it twice with water, and then heated for azeotropic dehydration. Then, after the obtained solution was microfiltrated to remove impurities, toluene was removed by distillation under a reduced pressure at a maximum temperature of 200°C to obtain 708 g of a solid product.

The mass spectrum (positive ion mode) of the obtained solid product was measured according to the measuring method described before. In the mass spectrum, the following spectral peaks were detected: m/z=969 which corresponds to the compound of m=2/n=1, m/z=1468 which corresponds to the compound of m=2/n=2, and m/z=1966 which corresponds to the compound of m=2/n=3. From these analytical data, it was confirmed that the obtained solid product had the intended molecular structure, i.e., the structure of the polyester resin (4a) containing the α-methylbenzyl group having the theoretical structure represented by the formula (4a).

### <Example 5: synthesis of polyester resin (5a) containing the α-methylbenzyl group>

### (5-1) Synthesis of aromatic dihydroxy compound (5x) containing the α-methylbenzyl group

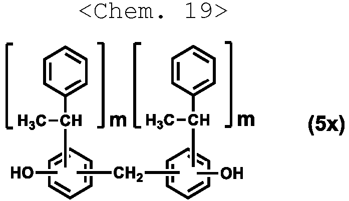

Into a four-necked round flask equipped with a stirrer, a thermometer, and a condenser, 300.0 g (1.5 moles) of bisphenol F (manufactured by Honshu Chemical Industry Co., Ltd.), 312.0 g (3.0 moles) of styrene monomer (reagent), 6.1 g of paratoluenesulfonic acid monohydrate (reagent) as the acid catalyst, and 1300 g of toluene as the reaction solvent were added so as to obtain a composition ratio that would give the total m value of 2.0 in the theoretical structure represented by the formula (5x) above; then, the temperature of the resulting mixture was raised to 100°C with taking care of the exothermic reaction. Then, the reaction was carried out at 100°C for 6 hours. After the temperature was then lowered to 60°C, 300 g of distilled water and an appropriate amount of a 48% sodium hydroxide aqueous solution for neutralization was added, which was followed by a static phase separation; then, the lower water phase containing the by-produced sodium chloride was discarded. The product was further purified by adding an equal volume of distilled water thereby washing it twice with water, and then heated for azeotropic dehydration. Then, after the obtained solution was microfiltrated to remove impurities, toluene was removed by distillation under a reduced pressure at a maximum temperature of 120°C to obtain 550 g of a solid product.

The hydroxy equivalent of this solid product was measured according to the measuring method described before to obtain a value of 207 g/eq. (theoretical value: 204 g/eq.).

The mass spectrum (negative ion mode) of the solid product was measured according to the measuring method described before. In the mass spectrum, the following spectral peaks were detected: m/z=304 which corresponds to the compound of "the total m value"=1, m/z=409 which corresponds to the compound of "the total m value"=2, and m/z=513 which corresponds to the compound of "the total m value"=3. No peaks of polyether structure, in which dihydroxy compounds were etherified with each other, were detected.

From these analytical data, it was confirmed that the obtained solid product had the intended molecular structure, i.e., the structure of the α-methylbenzyl-modified aromatic dihydroxy compound (5x) having the theoretical structure represented by the formula (5x).

### (5-2) Esterification reaction: synthesis of polyester resin (5a) containing the α-methylbenzyl group

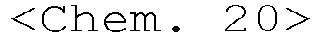

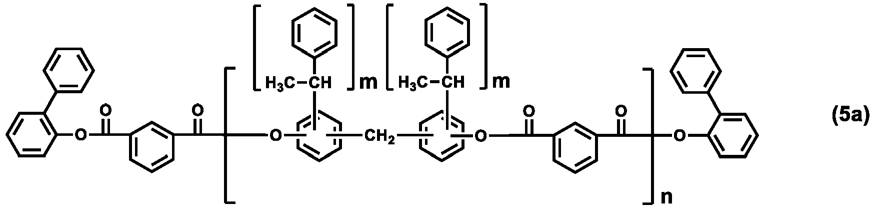

Into a four-necked round flask equipped with a stirrer, a thermometer, a dropping funnel, and a nitrogen gas inlet, 489.6 g (2.4 moles of hydroxy group) of the α-methylbenzyl-modified aromatic dihydroxy compound (5x) obtained at the step (5-1), 408.0 g (2.4 moles) of 2-phenylphenol (reagent), 487.2 g (2.4 moles) of isophthalic acid chloride (reagent), 1.4 g of tetra-n-butylammonium bromide (reagent), and 1250 g of toluene were added so as to obtain a composition ratio that would give the n value of 1.0 in the theoretical structure represented in the formula (5a) and the active ester equivalent of 252 g/eq.; then, while flowing a nitrogen gas, the resulting mixture was stirred to completely dissolve these compounds. At 30°C, 768.0 g (4.8 moles) of a 25% caustic soda aqueous solution was added dropwise over a period of 2 hours with raising the temperature finally to 60°C with taking care of the exothermic reaction. Then, after the stirring was further continued for 2 hours at 60°C, 300 g of distilled water was added, which was followed by a static phase separation; then, the lower water phase containing the by-produced sodium chloride was discarded. The product was further purified by adding an equal volume of distilled water thereby washing it twice with water, and then heated for azeotropic dehydration. Then, after the obtained solution was microfiltrated to remove impurities, toluene was removed by distillation under a reduced pressure at a maximum temperature of 200°C to obtain 785 g of a solid product.

The mass spectrum (positive ion mode) of the obtained solid product was measured according to the measuring method described before. In the mass spectrum, the following spectral peaks were detected: m/z=1009 which corresponds to the compound of "the total m value"=2/n=1, and m/z=1548 which corresponds to the compound of "the total m value"=2/n=2. From these analytical data, it was confirmed that the obtained solid product had the intended molecular structure, **i.e.,** the structure of the polyester resin (5a) containing the α-methylbenzyl group having the theoretical structure represented by the formula (5a).

### <Example 6: synthesis of polyester resin (6a) containing the α-methylbenzyl group>

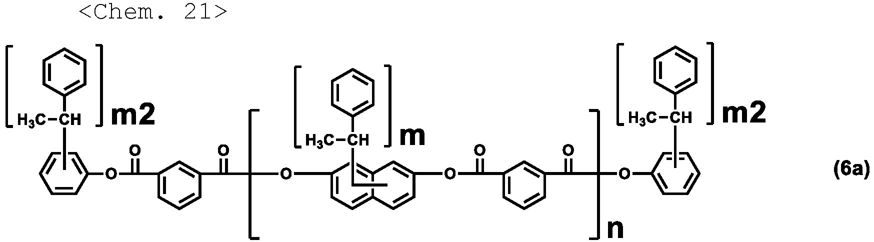

Into a four-necked round flask equipped with a stirrer, a thermometer, a dropping funnel, and a nitrogen gas inlet, 441.6 g (2.4 moles of hydroxy group) of the α-methylbenzyl-modified aromatic dihydroxy compound (1x) obtained by the same method as the step (1-1) in Example 1, 521.9 g (2.4 moles) of styrenated phenol (258 mg-KOH/g, manufactured by Sanko Co., Ltd.), 487.2 g (2.4 moles) of isophthalic acid chloride (reagent), 1.3 g of tetra-n-butylammonium bromide (reagent), and 1100 g of toluene were added so as to obtain a composition ratio that would give the n value of 1.0 in the theoretical structure represented by the formula (6a) and the active ester equivalent of 256 g/eq.; then, while flowing a nitrogen gas, the resulting mixture was stirred to completely dissolve these compounds. At 30°C, 512.0 g (3.2 moles) of a 25% caustic soda aqueous solution was added dropwise over a period of 2 hours with raising the temperature finally to 60°C with taking care of the exothermic reaction. Then, after the stirring was further continued for 2 hours at 60°C, 300 g of distilled water was added, which was followed by a static phase separation; then, the lower water phase containing the by-produced sodium chloride was discarded. The product was further purified by adding an equal volume of distilled water thereby washing it twice with water, and then heated for azeotropic dehydration. Then, after the obtained solution was microfiltrated to remove impurities, toluene was removed by distillation under a reduced pressure at a maximum temperature of 200°C to obtain 708 g of a solid product.

The mass spectrum (positive ion mode) of the obtained solid product was measured according to the measuring method described before. In the mass spectrum, the following spectral peaks were detected: m/z=1041 which corresponds to the compound of m=2/n=1, and m/z=1556 which corresponds to the compound of m=2/n=2. From these analytical data, it was confirmed that the obtained solid product had the intended molecular structure, i.e., the structure of the polyester resin (6a) containing the α-methylbenzyl group having the theoretical structure represented by the formula (6a).

### <Example 7: synthesis of polyester resin (7a) containing the α-methylbenzyl group>

### (7-1) Synthesis of aromatic dihydroxy compound (7x) containing the α-methylbenzyl group

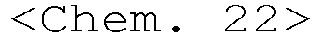

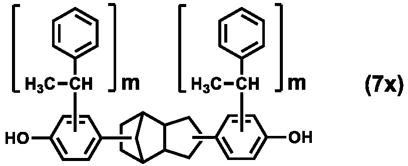

Into a four-necked round flask equipped with a stirrer, a thermometer, and a condenser, 495.0 g (1.5 moles) of dicyclopentadiene diphenol ("J-DPP-85", manufactured by JFE Chemical Corp., hydroxy equivalent of 165), 156.0 g (1.5 moles) of styrene monomer (reagent), 6.5 g paratoluenesulfonic acid monohydrate (reagent) as the acid catalyst, and 1200 g of toluene as the reaction solvent were added so as to obtain a composition ratio that would give the total m value of 1.0 in the theoretical structure represented by the formula (7x); then, the temperature of the resulting mixture was raised to 100°C with taking care of the exothermic reaction. Then, the reaction was carried out at 100°C for 6 hours. After the temperature was then lowered to 60°C, 300 g of distilled water and an appropriate amount of a 48% sodium hydroxide aqueous solution for neutralization was added, which was followed by a static phase separation; then, the lower water phase containing the by-produced sodium chloride was discarded. The product was further purified by adding an equal volume of distilled water thereby washing it twice with water, and then heated for azeotropic dehydration. Then, after the obtained solution was microfiltrated to remove impurities, toluene was removed by distillation under a reduced pressure at a maximum temperature of 120°C to obtain 605 g of a solid product.

The hydroxy equivalent of this solid product was measured according to the measuring method described before to obtain a value of 214 g/eq. (theoretical value: 212 g/eq.).

The mass spectrum (negative ion mode) of the solid product was measured according to the measuring method described before. In the mass spectrum, the following spectral peaks were detected: m/z=425 which corresponds to the compound of "the total m value"=1, m/z=529 which corresponds to the compound of "the total m value"=2, and m/z=633 which corresponds to the compound of "the total m value"=3. No peaks of polyether structure, in which dihydroxy compounds were etherified with each other, were detected.

From these analytical data, it was confirmed that the obtained solid product had the intended molecular structure, i.e., the structure of the α-methylbenzyl-modified aromatic dihydroxy compound (7x) having the theoretical structure represented by the formula (7x).

### (7-2) Esterification reaction: synthesis of polyester resin (7a) containing the α-methylbenzyl group

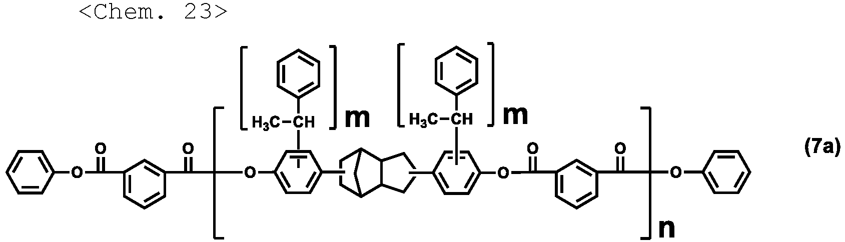

Into a four-necked round flask equipped with a stirrer, a thermometer, a dropping funnel, and a nitrogen gas inlet, 645.6 g (2.4 moles of hydroxy group) of the α-methylbenzyl-modified aromatic dihydroxy compound (7x) obtained at the step (7-1), 225.9 g (2.4 moles) of phenol (reagent), 487.2 g (2.4 moles) of isophthalic acid chloride (reagent), 1.4 g of tetra-n-butylammonium bromide (reagent), and 1200 g of toluene were added so as to obtain a composition ratio that would give the n value of 1.0 in the theoretical structure represented by the formula (7a) and the active ester equivalent of 269 g/eq.; then, while flowing a nitrogen gas, the resulting mixture was stirred to completely dissolve these compounds. At 30°C, 768.0 g (4.8 moles) of a 25% caustic soda aqueous solution was added dropwise over a period of 2 hours with raising the temperature finally to 60°C with taking care of the exothermic reaction. Then, after the stirring was further continued for 2 hours at 60°C, 300 g of distilled water was added, which was followed by a static phase separation; then, the lower water phase containing the by-produced sodium chloride was discarded. The product was further purified by adding an equal volume of distilled water thereby washing it twice with water, and then heated for azeotropic dehydration. Then, after the obtained solution was microfiltrated to remove impurities, toluene was removed by distillation under a reduced pressure at a maximum temperature of 200°C to obtain 860 g of a solid product.

The mass spectrum (positive ion mode) of the obtained solid product was measured according to the measuring method described before. In the mass spectrum, following spectral peaks were detected: m/z=873 which corresponds to the compound of "the total m value"=1/n=1, and m/z=1428 which corresponds to the compound of "the total m value"=1/n=2. From these analytical data, it was confirmed that the obtained solid product had the intended molecular structure, i.e., the structure of the polyester resin (7a) containing the α-methylbenzyl group having the theoretical structure represented by the formula (7a).

### <Example 8: synthesis of polyester resin (8a) containing the α-methylbenzyl group>

### (8-1) Synthesis of aromatic dihydroxy compound (8x) containing the α-methylbenzyl group

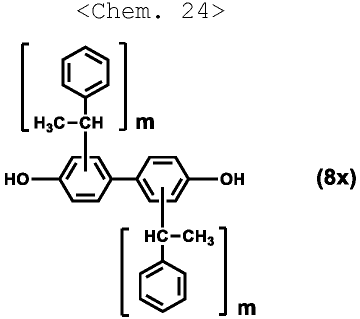

Into a four-necked round flask equipped with a stirrer, a thermometer, and a condenser, 279.3 g (1.5 moles) of 4,4'-biphenol (reagent), 468.0 g (4.5 moles) of styrene monomer (reagent), 7.5 g of paratoluenesulfonic acid monohydrate (reagent) as the acid catalyst, and 750 g of dimethyl sulfoxide as the reaction solvent were added so as to obtain a composition ratio that would give the total m value of 3.0 in the theoretical structure represented by the formula (8x); then, the temperature of the resulting mixture was raised to 130°C with taking care of the exothermic reaction. Then, the reaction was carried out at 130°C for 48 hours. After the temperature was then lowered to 60°C, 300 g of distilled water and an appropriate amount of a 48% sodium hydroxide aqueous solution for neutralization was added, which was followed by a static phase separation; then, the lower water phase containing the by-produced sodium chloride was discarded. The product was further purified by adding an equal volume of distilled water thereby washing it twice with water, and then heated for azeotropic dehydration. Then, after the obtained solution was microfiltrated to remove impurities, toluene and dimethyl sulfoxide were removed by distillation under a reduced pressure at a maximum temperature of 120°C to obtain 760 g of a solid product.

The hydroxy equivalent of this solid product was measured according to the measuring method described before to obtain a value of 253 g/eq. (theoretical value: 249 g/eq.).

The mass spectrum (negative ion mode) of the solid product was measured according to the measuring method described before. In the mass spectrum, the following spectral peaks were detected: m/z=290 which corresponds to the compound of "the total m value"=1, m/z=395 which corresponds to the compound of "the total m value"=2, and m/z=499 which corresponds to the compound of "the total m value"=3. No peaks of polyether structure, in which dihydroxy compounds were etherified with each other, were detected.

From these analytical data, it was confirmed that the obtained solid product had the intended molecular structure, i.e., the structure of the α-methylbenzyl-modified aromatic dihydroxy compound (8x) having the theoretical structure represented by the formula (8x).

### (8-2) Esterification reaction: synthesis of polyester resin (8a) containing the α-methylbenzyl group

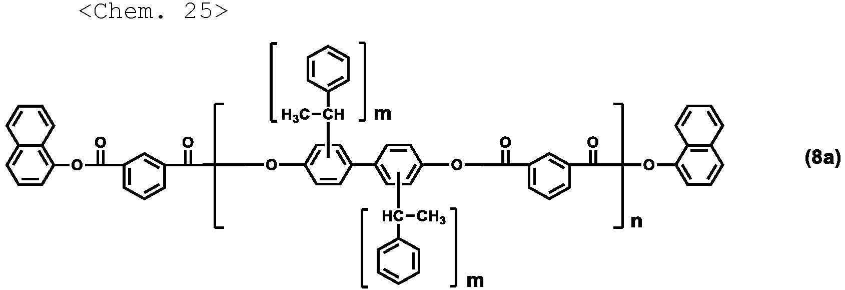

Into a four-necked round flask equipped with a stirrer, a thermometer, a dropping funnel, and a nitrogen gas inlet, 645.6 g (2.4 moles of hydroxy group) of the α-methylbenzyl-modified aromatic dihydroxy compound (8x) obtained at the step (8-1), 345.6 g (2.4 moles) of 1-naphthol (reagent), 487.2 g (2.4 moles) of isophthalic acid chloride (reagent), 1.5 g of tetra-n-butylammonium bromide (reagent), and 1300 g of toluene were added so as to obtain a composition ratio that would give the n value of 2.0 in the theoretical structure represented by the formula (8a) and the active ester equivalent of 279 g/eq.; then, while flowing a nitrogen gas, the resulting mixture was stirred to completely dissolve these compounds. At 30°C, 768.0 g (4.8 moles) of a 25% caustic soda aqueous solution was added dropwise over a period of 2 hours with raising the temperature finally to 60°C with taking care of the exothermic reaction. Then, after the stirring was further continued for 2 hours at 60°C, 300 g of distilled water was added, which was followed by a static phase separation; then, the lower water phase containing the by-produced sodium chloride was discarded. The product was further purified by adding an equal volume of distilled water thereby washing it twice with water, and then heated for azeotropic dehydration. Then, after the obtained solution was microfiltrated to remove impurities, toluene was removed by distillation under a reduced pressure at a maximum temperature of 200°C to obtain 810 g of a solid product.

The mass spectrum (positive ion mode) of the obtained solid product was measured according to the measuring described before. In the mass spectrum, the following spectral peaks were detected: m/z=943 which corresponds to the compound of "the total m value"=2/n=1, m/z=1468 which corresponds to the compound of "the total m value"=2/n=2, m/z=1047 which corresponds to the compound of "the total m value"=3/n=1, and m/z=1676 which corresponds to the compound of "the total m value"=3/n=2. From these analytical data, it was confirmed that the obtained solid product had the intended molecular structure, i.e., the structure of the polyester resin (8a) containing the α-methylbenzyl group having the theoretical structure represented by the formula (8a).

### <Comparative Example 1: synthesis of polyester resin (9) containing a benzyl group

### (C1-1) Synthesis of an aromatic dihydroxy compound (9x) containing a benzyl group

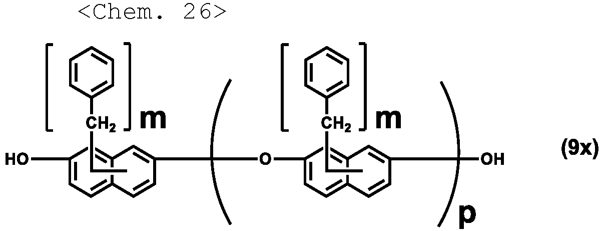

Into a four-necked round flask equipped with a stirrer, a thermometer, and a condenser, 224.0 g (1.4 moles) of 2,7-dihydroxynaphthalene, 302.4 g (2.8 moles) of benzyl alcohol, and 5.2 g of paratoluenesulfonic acid monohydrate (reagent) as the acid catalyst were added; then, with taking care of the exothermic reaction, the resulting mixture was heated to 150°C, and stirred for 4 hours while removing the generated water by distilling out from the system. After the temperature was then lowered to 60°C, 300 g of distilled water and an appropriate amount of a 48% sodium hydroxide aqueous solution for neutralization was added, which was followed by a static phase separation; then, the lower water phase containing the by-produced sodium chloride was discarded. The product was further purified by adding an equal volume of distilled water thereby washing it twice with water, and then heated for azeotropic dehydration. Then, after the obtained solution was microfiltrated to remove impurities, toluene was removed by distillation under a reduced pressure at a maximum temperature of 120°C to obtain 450 g of a solid product.

The hydroxy equivalent of this solid product was measured according to the measuring method described before to obtain a value of 200 g/eq.

The mass spectrum (negative ion mode) of the solid product was measured according to the measuring method described before. In the mass spectrum, the following spectral peaks were confirmed: m/z=250 which corresponds to the structure having one benzyl group added to 2,7-dihydroxynaphthalene, m/z=340 which corresponds to the structure having two benzyl groups added, and m/z=430 which corresponds to the structure having three benzyl groups added. In addition, the following peaks were confirmed: m/z=392 which corresponds to the structure having one benzyl group added to a dimer of 2,7-dihydroxynaphthalene formed by a bimolecular dehydration of 2,7-dihydroxynaphthalene, m/z=483 which corresponds to the structure having two benzyl groups added, m/z=573 which corresponds to the structure having three benzyl groups added, and m/z=663 which corresponds to the structure having four benzyl groups added. Furthermore, following peaks were confirmed: m/z=535 which corresponds to the structure having one benzyl group added to a trimer of 2,7-dihydroxynaphthalene formed by a trimolecular dehydration of 2,7-dihydroxynaphthalene, m/z=625 which corresponds to the structure having two benzyl groups added, m/z=715 which corresponds to the structure having three benzyl groups added, and m/z=805 which corresponds to the structure having four benzyl groups added.

These analytical data confirmed that the obtained solid product had a benzyl-modified dihydroxynaphthalene structure and a benzyl-modified dihydroxypolynaphthylene ether structure, as represented by the formula (9x).

### (C1-2) Esterification reaction: synthesis of polyester resin (9a) containing the benzyl group

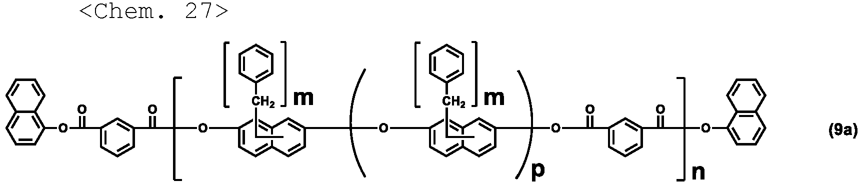

Into a four-necked round flask equipped with a stirrer, a thermometer, a dropping funnel, and a nitrogen gas inlet, 480 g (2.4 moles of hydroxy group) of the benzyl-modified aromatic dihydroxy compound (9x) obtained at the step (C1-1), 345.6 g (2.4 moles) of 1-naphthol (reagent), 487.2 g (2.4 moles) of isophthalic acid chloride (reagent), 1.5 g of tetra-n-butylammonium bromide (reagent), and 1300 g of toluene were added so as to obtain a composition ratio that would give the n value of 2.0 in the theoretical structure represented by the formula (9a) and the active ester equivalent of 247 g/eq.; then, while flowing a nitrogen gas, the resulting mixture was stirred to completely dissolve these compounds. At 30°C, 768.0 g (4.8 moles) of a 25% caustic soda aqueous solution was added dropwise over a period of 2 hours with raising the temperature finally to 60°C with taking care of the exothermic reaction. Then, after the stirring was further continued for 2 hours at 60°C, 300 g of distilled water was added, which was followed by a static phase separation; then, the lower water phase containing the by-produced sodium chloride was discarded. The product was further purified by adding an equal volume of distilled water thereby washing it twice with water, and then heated for azeotropic dehydration. Then, after the resulting solution was microfiltrated to remove impurities, toluene was removed by distillation under a reduced pressure at a maximum temperature of 200°C to obtain 770 g of a solid product.

The mass spectrum (positive ion mode) of the obtained solid product was measured according to the measuring method described before. In the mass spectrum, the following spectral peaks were detected: m/z=889 which corresponds to the compound of p=0/m=2/n=1, m/z=1211 which corresponds to the compound of p=1/m=2/n=1, and m/z=1360 which corresponds to the compound of p=0/m=2/n=2. From these analytical data, it was confirmed that the obtained solid had the intended molecular structure, i.e., the structure of the polyester resin (9a) having a benzyl-modified polynaphthylene ether structure with the theoretical structure represented by the formula (9a).

### <Examples 9 to 16 and Comparative Example 2>

### (1) Preparation of resin composition

The synthesized polyester resins (1a) to (9a), the bisphenol A type liquid epoxy resin ("850S"; manufactured by DIC Corp., epoxy equivalent of 183 g/eq.), and the biphenyl aralkyl type epoxy resin ("NC3000"; manufactured by Nippon Kayaku Co., Ltd., epoxy equivalent of 275 g/eq.), with the composition described in Table 1, were melt-mixed at 150°C. Then, 4-dimethylaminopyridine ("DMAP"; manufactured by Koei Chemical Co., Ltd.) was mixed to prepare the resin composition.

### (2) Production of cured product

The resin composition thus prepared was filled into a metal mold (100 mm x 100 mm x 0.5 mm) that had applied with a releasing agent. Then the resin composition was thermally cured at 150°C for 10 minutes to obtain a cured product. The resulting cured product was taken out from the metal mold. The cured product was further thermally cured at 200°C for 3 hours to produce a sheet-shaped cured product.

### (3) Evaluation of the cured product

Evaluation tests were conducted on the sheet-shaped cured product by the following procedure.

### <Measurement of dielectric properties (room temperature)>

The sheet-shaped cured product was cut into test pieces having a predetermined size, and a relative dielectric constant and a dielectric dissipation factor thereof were measured using a split cylinder resonator ("CR-710" manufactured by EM Labs, Inc.) and a PNA microwave network analyzer ("N5227B" manufactured by Keysight Technologies, Inc.) with a measurement frequency of 5.8 GHz and a temperature of 23°C. For each cured product, five test pieces were measured (n=5), and the average value thereof was calculated.

### <Measurement of dielectric properties (high temperature)>

The sheet-shaped cured product was cut into a test piece having a predetermined size, and a relative dielectric constant and a dielectric dissipation factor thereof were measured using a split cylinder resonator ("CR-710" manufactured by EM Labs, Inc.) and a PNA microwave network analyzer ("N5227B" manufactured by Keysight Technologies, Inc.) with a measurement frequency of 10 GHz and a temperature of 90°C. For each cured product, five test pieces were measured (n=5), and the average value thereof was calculated.

### (3) Results of Examples 9 to 16 and Comparative Example 2

The measurement results of Examples 9 to 16 and Comparative Example 2 are summarized in Table 1. In Table 1, the unit for the amount of each component is expressed by parts by mass. In Table 1, the abbreviations have the following meanings.
Dk: relative dielectric constant
Df: dielectric dissipation factor

**<Table 1>**

| **<Table 1. Results of Examples 9 to 16 and Comparative Example 2>** | | | | | | | | | | |
|---|---|---|---|---|---|---|---|---|---|---|
| | | Example | | | | | | | | Comparative Example |
| | | 9 | 10 | 11 | 12 | 13 | 14 | 15 | 16 | 2 |
| Polyester resin | 1a | 23 | | | | | | | | |
| | 2a | | 23 | | | | | | | |
| | 3a | | | 23 | | | | | | |
| | 4a | | | | 25 | | | | | |
| | 5a | | | | | 25 | | | | |
| | 6a | | | | | | 26 | | | |
| | 7a | | | | | | | 27 | | |
| | 8a | | | | | | | | 28 | |
| | 9a | | | | | | | | | 25 |
| 850S | | 11 | 11 | 11 | 11 | 11 | 11 | 11 | 11 | 11 |
| NC3000 | | 11 | 11 | 11 | 11 | 11 | 11 | 11 | 11 | 11 |
| DMAP | | 0.2 | 0.2 | 0.2 | 0.2 | 0.2 | 0.2 | 0.2 | 0.2 | 0.2 |
| Dielectric properties (room temperature) | Dk | 2.6 | 2.7 | 2.6 | 2.7 | 2.7 | 2.7 | 2.6 | 2.6 | 2.9 |
| | Df | 0.0057 | 0.0058 | 0.0058 | 0.0059 | 0.0059 | 0.0059 | 0.0058 | 0.0057 | 0.0070 |
| Dielectric properties (90°C) | Dk | 2.6 | 2.7 | 2.6 | 2.7 | 2.7 | 2.7 | 2.6 | 2.6 | 2.9 |
| | Df | 0.0072 | 0.0073 | 0.0074 | 0.0073 | 0.0075 | 0.0076 | 0.0075 | 0.0073 | 0.0094 |

### <Examples 17 to 24 and Comparative Example 3>

### (1) Preparation of resin composition varnish

With the compositions described in Table 2, the synthesized polyester resins (1a) to (9a), the bisphenol A type liquid epoxy resin ("850S"; manufactured by DIC Corp., epoxy equivalent of 183 g/eq.), the biphenyl aralkyl type epoxy resin ("NC3000H"; manufactured by Nippon Kayaku Co., Ltd., epoxy equivalent of 291 g/eq.), 4-dimethylaminopyridine ("DMAP"; manufactured by Koei Chemical Co., Ltd.), the phenoxy resin ("YL6954BH30"; manufactured by Mitsubishi Chemical Corp.), the spherical silica ("SO-C2"; manufactured by Admatechs Co., Ltd., average particle diameter of 0.50 um), methyl ethyl ketone (MEK), and cyclohexanone were mixed to prepare a resin composition varnish.

### (2) Preparation of resin sheet

The prepared resin composition varnish was applied onto a polyethylene terephthalate film (thickness of 38 µm; hereinafter this is referred to as briefly "PET film") by means of a die coater such that the thickness of the resin composition layer after drying would become 40 µm. This was then dried at 80°C to 120°C (average 100°C) for 6 minutes to prepare a resin sheet.

### (3) Production of cured product

The resin sheet thus prepared was then heated at 190°C for 120 minutes to thermally cure the resin composition layer. Next, the PET film was removed to obtain a sheet-shaped cured product.

### (4) Evaluation of the cured product

Evaluation tests were conducted on the sheet-shaped cured product by the following procedure.

### <Measurement of dielectric properties (high temperature)>

Evaluation tests of the dielectric properties of the sheet-shaped cured products obtained in Examples 17 to 24 and Comparative Example 3 were conducted in the same procedure as in Examples 9 to 16 and Comparative Example 2.

### <Evaluation of smear removability>

### (Surface treatment of inner layer board)

A both-surface copper clad epoxy resin-impregnated glass cloth substrate ("R1515A"; manufactured by Panasonic Corp.; thickness of the copper foil: 18 µm, thickness of the substrate: 0.8 mm) that included cupper foil on both surfaces was prepared as the inner layer board. The copper foils on the surfaces of the inner layer board were roughened by etching using a micro-etching agent ("CZ8101"; manufactured by MEC Co., Ltd.) with the copper etching amount of 1 µm. Then, this was dried at 190°C for 30 minutes.

### (Lamination and curing of the resin sheet)

By using a batch-type vacuum press laminator ("CVP700"; 2-stage build-up laminator, manufactured by Nikko Materials Co., Ltd.), the resin sheet obtained in each of Examples and Comparative Examples was laminated onto both surfaces of the inner layer board such that the resin composition layer would be in contact with the surface of the inner layer board. The lamination was performed by evacuating over 30 seconds to bring the pressure to 13 hPa or less, followed by pressing to bond with the pressure of 0.74 MPa and the temperature of 100°C for 30 seconds.

Next, this laminated resin sheet was flattened by hot-pressing with the pressure of 0.5 MPa at 100°C for 60 seconds under an atmospheric pressure. This was then heated in an oven at 130°C for 30 minutes, followed by heating at 170°C in another oven for 30 minutes. The resin composition layer was cured by the heating described above to obtain an insulating layer containing the cured product of the resin composition. By the above-mentioned operation, an intermediate substrate having a layer structure of PET film/insulating layer/inner layer board/insulating layer/PET film was obtained.

### (Formation of via holes)

The via holes were formed in the insulating layer by processing the insulating layer using a CO₂ laser machine (LK-2K212/2C; manufactured by Via Mechanics, Ltd.). This processing was performed with a frequency of 2000 Hz, a pulse width of 3 µsec, an output power of 0.95 W, and a shot number of 3. The formed via holes had a top diameter (diameter) of 50 µm at the front surface of the insulating layer and a diameter of 40 µm at the bottom surface of the insulating layer. The top diameter means the diameter of the opening of the via hole. Thereafter, the PET film was removed.

### (Roughening treatment)

The intermediate substrate was immersed in Swelling Dip Securiganth P as the swelling liquid manufactured by Atotech Japan Co., Ltd. at 60°C for 10 minutes. Next, the intermediate substrate was immersed in Concentrate Compact P (an aqueous solution of KMnO₄: 60 g/L, NaOH: 40 g/L) as the roughening solution manufactured by Atotech Japan Co., Ltd. at 80°C for 20 minutes. The intermediate substrate was then immersed in Reduction Solution Securiganth P as the neutralizing solution manufactured by Atotech Japan Co., Ltd. at 40°C for 5 minutes. The resulting intermediate substrate is called Evaluation Substrate A.

### (Evaluation of smear removability)

The area around the bottom (via bottom) of the via hole of Evaluation Substrate A was observed using a scanning electron microscope (SEM). From the image obtained from this observation, the maximum smear length from the wall surface at the bottom of the via hole was measured and evaluated in accordance with the following criteria. The maximum smear length indicates the length of the longest smear among smears formed at the bottom of the via hole.
"○": Maximum smear length is less than 5 µm.
"×": Maximum smear length is 5 µm or more.

### <Evaluation of haloing>

Cross-sectional observation of Evaluation Substrate A was performed using a FIB-SEM combined instrument ("SMI3050SE" manufactured by SII Nanotechnology Inc.). Specifically, the focused ion beam (FIB) was used to cut the insulating layer so that a cross section parallel to the thickness direction of said insulating layer and passing through the center of the via bottom of the via hole would appear. This cross-section was observed by SEM. The bottom diameter and the top diameter of the via hole were measured from the observed image. The bottom diameter means the diameter of the bottom of the via hole, and the top diameter means the diameter of the opening of the via hole.

The image observed by SEM indicated a gap formed by separation of the insulating layer from the copper foil of the inner layer board, continuously from the edge of the via bottom. Therefore, from the observed image, the distance (corresponding to the inner radius of the gap) r1 from the center of the via bottom to the edge of the via bottom and the distance (corresponding to the outer radius of the gap) r2 from the center of the via bottom to the far end of the gap were measured, and the difference between these distances r1 and r2, i.e., r2-r1 was calculated as the haloing distance from the edge of the via bottom at that measurement point.

The measurement was made on 5 via holes selected randomly. The average of the top diameters of the 5 measured via holes was then adopted as the top diameter Lt after the roughening treatment in that sample. The average of the bottom diameters of the 5 measured via holes was adopted as the bottom diameter Lb after the roughening treatment in that sample. Further, the average of the haloing distances of the 5 measured via holes was adopted as the haloing distance Wb from the edge of the via bottom in that sample.

The haloing ratio Hb (the ratio "Wb/(Lb/2)" of the haloing distance Wb from the edge of the via bottom after the roughening treatment with respect to the radius (Lb/2) of the via bottom of the via hole after the roughening treatment) was calculated from the measurement results. When the haloing ratio Hb was 50% or less, this was judged as "○", and when the haloing ratio Ht was greater than 50%, it was judged as "×".

### (5) Results of Examples 17 to 24 and Comparative Example 3

The measurement results of Examples 17 to 24 and Comparative Example 3 are summarized in Table 2. In Table 2, the unit for the amount of each component is expressed by parts by mass. In Table 2, the abbreviations have the following meanings.
Dk: relative dielectric constant
Df: dielectric dissipation factor

**[Table 2]**

| **<Table 2. Results of Examples 17 to 24 and Comparative Example 3>** | | | | | | | | | | |
|---|---|---|---|---|---|---|---|---|---|---|
| | | Example | | | | | | | | Comparative Example |
| | | 17 | 18 | 19 | 20 | 21 | 22 | 23 | 24 | 3 |
| Polyester resin | 1a | 23 | | | | | | | | |
| | 2a | | 23 | | | | | | | |
| | 3a | | | 23 | | | | | | |
| | 4a | | | | 25 | | | | | |
| | 5a | | | | | 25 | | | | |
| | 6a | | | | | | 26 | | | |
| | 7a | | | | | | | 27 | | |
| | 8a | | | | | | | | 28 | |
| | 9a | | | | | | | | | 25 |
| 850S | | 11 | 11 | 11 | 11 | 11 | 11 | 11 | 11 | 11 |
| NC3000H | | 11 | 11 | 11 | 11 | 11 | 11 | 11 | 11 | 11 |
| DMAP | | 0.15 | 0.15 | 0.15 | 0.15 | 0.15 | 0.15 | 0.15 | 0.15 | 0.15 |
| YL6954BH30 | | 15 | 15 | 15 | 15 | 15 | 15 | 15 | 15 | 15 |
| SO-C2 | | 300 | 300 | 300 | 300 | 300 | 300 | 300 | 300 | 300 |
| MEK | | 15 | 15 | 15 | 15 | 15 | 15 | 15 | 15 | 15 |
| Cyclohexanone | | 30 | 30 | 30 | 30 | 30 | 30 | 30 | 30 | 30 |
| Dielectric properties (room temperature) | Dk | 3.2 | 3.2 | 3.2 | 3.2 | 3.2 | 3.3 | 3.2 | 3.2 | 3.3 |
| | Df | 0.0022 | 0.0023 | 0.0023 | 0.0024 | 0.0025 | 0.0024 | 0.0023 | 0.0022 | 0.0028 |
| Dielectric properties (90°C) | Dk | 3.3 | 3.3 | 3.2 | 3.3 | 3.3 | 3.3 | 3.3 | 3.3 | 3.4 |
| | Df | 0.0026 | 0.0027 | 0.0028 | 0.0028 | 0.0028 | 0.0027 | 0.0027 | 0.0026 | 0.0036 |
| Smear removability | | O | O | O | O | O | O | O | O | X |
| Haloing evaluation | | O | O | O | O | O | O | O | O | X |

### <Discussion>

As can be seen in Tables 1 and 2, it was confirmed that the cured product having excellent dielectric properties at a high temperature was able to be obtained when the resin composition contained the active ester resin of the present invention. It was also confirmed that, even when the active ester resin of the present invention was used as a resin crosslinking agent, the cured product exhibiting excellent dielectric properties at a high temperature was able to be obtained. Moreover, it was confirmed that the resin composition containing the active ester resin of the present invention usually produced the cured product having a good smear removability and a small haloing.

## Claims

1. An active ester resin comprising one or more of α-methylbenzyl groups per one molecule.

2. The active ester resin according to claim 1, including a partial structure represented by the following formula (I): 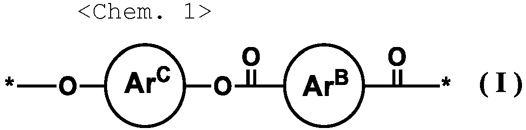 (In the formula (I),
the group Ar^{B} each independently represents a divalent organic group containing at least one aromatic ring,
the group Ar^{C} each independently represents a divalent organic group containing at least one aromatic ring, and
* represents a bond).

3. The active ester resin according to claim 1, represented by the following formula (II): 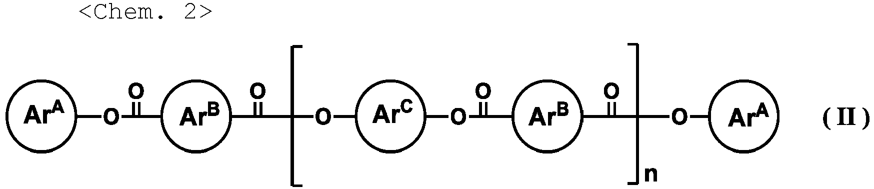 (In the formula (II),
the group Ar^{A} each independently represents a monovalent organic group containing at least one aromatic ring,
the group Ar^{B} each independently represents a divalent organic group containing at least one aromatic ring,
the group Ar^{C} each independently represents a divalent organic group containing at least one aromatic ring,
at least one of the organic group Ar^{A}, the organic group Ar^{B}, and the organic group Ar^{C} contains the α-methylbenzyl group, and
n represents a number more than 0).

4. The active ester resin according to claim 2, wherein the organic group Ar^{C} represents a divalent hydrocarbon group containing at least one aromatic ring.

5. The active ester resin according to claim 2, wherein the organic group Ar^{C} contains the α-methylbenzyl group.

6. The active ester resin according to claim 1, including an aromatic ring to which the α-methylbenzyl group is bonded.

7. The active ester resin according to claim 6, wherein on average 1 to 6 α-methylbenzyl groups are bonded to one aromatic ring to which the α-methylbenzyl group is bonded.

8. The active ester resin according to claim 1, wherein an amount of the α-methylbenzyl group is in a range of 1% by mass to 60% by mass.

9. The active ester resin according to claim 1, wherein the active ester resin is a condensation reaction product of (X1) an aromatic polyvalent hydroxy compound including (X-1) a modified aromatic polyvalent hydroxy compound containing the α-methylbenzyl group, (X2) an aromatic carboxylic acid compound or an aromatic carboxylic acid halide compound, and (X3) an aromatic monohydroxy compound.

10. A production method of the active ester resin according to any one of claims 1 to 9, the method comprising:
a step of reacting (X1) an aromatic polyvalent hydroxy compound including (X1-1) a modified aromatic polyvalent hydroxy compound containing the α-methylbenzyl group, (X2) an aromatic carboxylic acid compound or an aromatic carboxylic acid halide compound, and (X3) an aromatic monohydroxy compound.

11. A resin crosslinking agent comprising the active ester resin according to any one of claims 1 to 9.

12. A resin composition comprising the active ester resin according to any one of claims 1 to 9 and a crosslinkable resin.

13. The resin composition according to claim 12, wherein the crosslinkable resin includes one or more resins selected from the group consisting of a thermosetting resin and a radical polymerizable resin.

14. The resin composition according to claim 12, which is for forming an insulating layer of a printed wiring board.

15. The resin composition according to claim 12, which is for sealing of a semiconductor chip.

16. A cured product of the resin composition according to claim 12.

17. A sheet-shaped laminate material comprising the resin composition according to claim 12.

18. A resin sheet comprising:
a support, and
a resin composition layer formed on the support, wherein
the resin composition layer comprises the resin composition according to claim 12.

19. A printed wiring board comprising an insulating layer comprising a cured product of the resin composition according to claim 12.

20. A semiconductor chip package comprising a sealing layer comprising a cured product of the resin composition according to claim 12.

21. The semiconductor chip package according to claim 20, which is a Fan-Out type package.

22. A semiconductor device comprising the printed wiring board according to claim 19.

23. A semiconductor device comprising the semiconductor chip package according to claim 20.
